(19) 

**Europäisches Patentamt**
**European Patent Office**
**Office européen des brevets**

(11) **EP 4 694 311 A1**

(12) **EUROPEAN PATENT APPLICATION**
published in accordance with Art. 153(4) EPC

(43) Date of publication:
**11.02.2026 Bulletin 2026/07**

(21) Application number: **23934541.6**

(22) Date of filing: **27.04.2023**

(51) International Patent Classification (IPC):
**H04W 28/06** (2009.01)　　　**H04L 69/04** (2022.01)

(52) Cooperative Patent Classification (CPC):
**H04L 69/04; H04W 28/06**

(86) International application number:
**PCT/CN2023/091226**

(87) International publication number:
**WO 2024/221344 (31.10.2024 Gazette 2024/44)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Huawei Technologies Co., Ltd.**
**Shenzhen, Guangdong 518129 (CN)**

(72) Inventors:
• **LI, Jiahui**
  **Shenzhen, Guangdong 518129 (CN)**
• **MA, Mengyao**
  **Shenzhen, Guangdong 518129 (CN)**
• **XIE, Junwen**
  **Shenzhen, Guangdong 518129 (CN)**
• **BI, Xiaoyan**
  **Shenzhen, Guangdong 518129 (CN)**

(74) Representative: **Maiwald GmbH**
**Elisenhof**
**Elisenstraße 3**
**80335 München (DE)**

(54) **COMMUNICATION METHOD, COMMUNICATION APPARATUS, MEDIUM, AND PROGRAM PRODUCT**

(57)　This application provides a communication method, a communication apparatus, a computer-readable storage medium, and a computer program product. The communication method includes: A first communication apparatus obtains training data, where the training data is used to train a dictionary used for data compression; determines a group of to-be-updated subsets in the dictionary based on the training data; determines dictionary update information corresponding to the group of to-be-updated subsets; and sends the dictionary update information. In this way, efficient dictionary update can be supported, thereby reducing computing resources and wireless transmission resources consumed by dictionary update.

FIG. 2

## Description

## TECHNICAL FIELD

This application relates to the communication field, and more specifically, to a communication method, a communication apparatus, a computer-readable storage medium, and a computer program product.

## BACKGROUND

With the development of wireless communication technologies, higher requirements have been proposed for data transmission, for example, higher throughput, lower latency, and higher accuracy. When a data amount is large, compression operations are required before data transmission, to reduce consumption of wireless transmission resources. To improve compression efficiency, a plurality of data compression technologies have been proposed, such as discrete cosine transform (Discrete Cosine Transform, DCT), discrete Fourier transform (Discrete Fourier Transform, DFT), discrete wavelet transform (Discrete Wavelet Transform, DWT), and entropy coding. If the foregoing data compression modes are used, when a compression rate is high, data transmission performance deteriorates; or when a compression rate is low, a large quantity of transmission resources are occupied, resulting in high transmission resource overheads. Therefore, there is still a need for improved technologies to meet requirements for higher accuracy and lower resource consumption.

## SUMMARY

In view of this, embodiments of this application provide a communication method based on a dynamic dictionary used for data compression, a communication apparatus, a computer-readable storage medium, and a computer program product.

According to a first aspect, a method is provided. The method includes: A first communication apparatus obtains training data, where the training data is used to train a dictionary used for data compression; determines a group of to-be-updated subsets in the dictionary based on the training data; determines dictionary update information corresponding to the group of to-be-updated subsets; and sends the dictionary update information. In this way, efficient dictionary update can be supported, thereby reducing computing resources and wireless transmission resources consumed by dictionary update. Therefore, accuracy of dictionary compression can be improved.

According to a second aspect, a method is provided. For beneficial effects, refer to the descriptions of the first aspect. Details are not described herein again. The method includes: A second communication apparatus receives, from a first communication apparatus, dictionary update information for a dictionary used for data compression, where the dictionary update information includes indication information of a subset in a group of to-be-updated subsets in the dictionary and an update value corresponding to the subset in the group of to-be-updated subsets; and updates the dictionary based on the dictionary update information.

According to a third aspect, a first communication apparatus is provided. The first communication apparatus includes modules or units configured to perform the method according to the first aspect.

According to a fourth aspect, a second communication apparatus is provided. The second communication apparatus includes modules or units configured to perform the method according to the second aspect.

According to a fifth aspect, a first communication apparatus is provided. The first communication apparatus includes a processor, where the processor is coupled to a memory, the memory stores instructions, and when the instructions are executed by the processor, the first communication apparatus is caused to perform the method according to the first aspect.

According to a sixth aspect, a second communication apparatus is provided. The second communication apparatus includes a processor, where the processor is coupled to a memory, the memory stores instructions, and when the instructions are executed by the processor, the second communication apparatus is caused to perform the method according to the second aspect.

According to a seventh aspect, a computer-readable storage medium is provided. The computer-readable storage medium stores instructions, and when the instructions are run, the method according to any one of the first aspect or the implementations of the first aspect is performed.

According to an eighth aspect, a computer-readable storage medium is provided. The computer-readable storage medium stores instructions, and when the instructions are run, the method according to any one of the second aspect or the implementations of the second aspect is performed.

According to a ninth aspect, a computer program product is provided. The computer program product includes instructions, and when the instructions are run, the method according to any one of the first aspect or the implementations of the first aspect is performed.

According to a tenth aspect, a computer program product is provided. The computer program product includes instructions, and when the instructions are run, the method according to any one of the second aspect or the implementations of the second aspect is performed.

According to an eleventh aspect, a communication system is provided. The communication system includes the first communication apparatus according to the third aspect or the fifth aspect and the second communication apparatus according to the fourth aspect or the seventh aspect.

**BRIEF DESCRIPTION OF DRAWINGS**

The foregoing and other features, advantages, and aspects of embodiments of this application become clearer with reference to the accompanying drawings and the following detailed descriptions. In the accompanying drawings, same or similar reference numerals indicate same or similar elements.

FIG. 1 is a diagram of a communication system to which an embodiment of this application is applicable;

FIG. 2 is an interaction signaling diagram of a dictionary update method according to some embodiments of this application;

FIG. 3A is a diagram of an example implementation of a method for determining dictionary update information according to some embodiments of this application;

FIG. 3B is a diagram of an example implementation of a method for compressing a dictionary update value according to some embodiments of this application;

FIG. 3C is a diagram of an example implementation of compression control information according to some embodiments of this application;

FIG. 4 is a diagram of an example implementation of a method for selecting training data according to some embodiments of this application;

FIG. 5A is a diagram of an example implementation of a method for periodically updating a dictionary according to some embodiments of this application;

FIG. 5B is a diagram of an example implementation of a method for aperiodically updating a dictionary according to some embodiments of this application;

FIG. 6A is a diagram of an example implementation of a method for periodically updating a dictionary according to some embodiments of this application;

FIG. 6B is a diagram of an example implementation of a method for aperiodically updating a dictionary according to some embodiments of this application;

FIG. 7A is a diagram of an example implementation of a method for compressing channel state information according to some embodiments of this application;

FIG. 7B is a diagram of an example implementation of a dictionary compression method according to some embodiments of this application;

FIG. 8A and FIG. 8B are diagrams of example implementations of a bit sequence set according to some embodiments of this application;

FIG. 9A to FIG. 9D are diagrams of example implementations of information including a dictionary compression parameter according to some embodiments of this application;

FIG. 10 is a schematic flowchart of a method implemented at a first communication apparatus according to some embodiments of this application;

FIG. 11 is a schematic flowchart of a method implemented at a second communication apparatus according to some embodiments of this application;

FIG. 12 is a diagram of main composition of an example device in a possible implementation according to an embodiment of the present disclosure; and

FIG. 13 is a simplified block diagram of an example device in a possible implementation according to an embodiment of the present disclosure.

**DESCRIPTION OF EMBODIMENTS**

The following describes embodiments of this application in more detail with reference to the accompanying drawings. Although some embodiments of this application are shown in the accompanying drawings, it should be understood that this application may be implemented in various forms, and should not be construed as being limited to embodiments described herein. On the contrary, these embodiments are provided for a more thorough and complete understanding of this application. It should be understood that, the accompanying drawings and embodiments of this application are merely used as examples, and are not intended to limit the protection scope of this application.

Embodiments of this application may be implemented according to any suitable communication protocol, including but not limited to cellular communication protocols such as a fourth generation ($4^{th}$ generation, 4G) communication protocol, a fifth generation ($5^{th}$ generation, 5G) communication protocol, and a communication protocol evolved from 5G (for example, a sixth generation ($6^{th}$ generation, 6G) communication protocol), a wireless local area network communication protocol like the Institute of Electrical and Electronics Engineers (Institute of Electrical and Electronics Engineers, IEEE) 802.11, and/or any other protocol currently known or developed in the future.

The technical solutions in embodiments of this application are applied to a communication system that complies with any suitable communication protocol, for example, a long term evolution (Long Term Evolution, LTE) system, a frequency division duplex (Frequency Division Duplex, FDD) system, a time division duplex (Time Division Duplex, TDD) system, a 5G system (for example, NR), and a communication system evolved from 5G (for example, a 6G system).

For the purpose of description, the following describes embodiments of this application in the background of a cellular communication system in the 3rd generation partnership project ($3^{rd}$ Generation Partnership Project, 3GPP). However, it should be understood that embodiments of this application are not limited to the communication system, but may be applied to any communication system having a similar problem, for example, a wireless local area network (Wireless Local Area Network, WLAN), a wired communication system, or another communication system developed in the future.

The term "terminal" or "terminal device" used in the present disclosure refers to any terminal device that can perform wired or wireless communication with a network device or any terminal devices that can perform wired or wireless communication with each other. The terminal device may be sometimes referred to as user equipment or UE. The terminal device may be any type of mobile terminal, fixed terminal, or portable terminal. The terminal device may be various wireless communication devices that have a wireless communication function. With emergence of an internet of things (Internet of Things, IoT) technology, more devices that previously have no communication function, for example without limitation to, a household appliance, a transportation tool, a tool device, a service device, and a service facility, start to obtain a wireless communication function by being configured with a wireless communication unit, to access a wireless communication network, and accept remote control. Such a device has the wireless communication function because the device is configured with the wireless communication unit, and therefore also belongs to a scope of wireless communication devices. For example, the terminal device may include a mobile cellular phone, a cordless phone, a mobile terminal (Mobile Terminal, MT), a mobile station, a mobile device, a wireless terminal, a handheld device, a client, a subscription station, a portable subscription station, an Internet node, a communicator, a desktop computer, a laptop computer, a notebook computer, a tablet computer, a personal communication system device, a personal navigation device, a personal digital assistant (Personal Digital Assistant, PDA), a wireless data card, a wireless modem (Modulator demodulator, Modem), a positioning device, a radio broadcast receiver, an e-book device, a game device, an IoT device, a vehicle-mounted device, an aircraft, a virtual reality (Virtual Reality, VR) device, an augmented reality (Augmented Reality, AR) device, a wearable device (for example, a smartwatch), a terminal device in a 5G network or any terminal device in an evolved public land mobile network (Public Land Mobile Network, PLMN), another device that can be used for communication, or any combination thereof. This is not limited in embodiments of this application.

The term "network node" or "network device" used in this application is an entity or a node that may be configured to communicate with the terminal device, for example, may be an access network device. The access network device may be an apparatus that is deployed in a radio access network and that provides a wireless communication function for a mobile terminal, and may be, for example, a radio access network (Radio Access Network, RAN) network device. The access network device may include various types of base stations. The base station is configured to provide a wireless access service for the terminal device. Based on a size of a provided service coverage area, the access network device may include a macro base station providing a macro cell (Macro cell), a micro base station providing a micro cell (Pico cell), a pico base station providing a pico cell, and a femto base station providing a femto cell (Femto cell). In addition, the access network device may further include various forms of satellites, relay stations, access points, remote radio units (Remote Radio Unit, RRU), radio heads (Radio Head, RH), remote radio heads (Remote Radio Head, RRH), transmitting and receiving points (transmitting and receiving point, TRP), transmitting points (transmitting point, TP), and the like. In systems using different radio access technologies, the access network device may have different names. For example, the access network device is referred to as an evolved NodeB (evolved NodeB, eNB or eNodeB) in an LTE network, is referred to as a NodeB (NodeB, NB) in a 3G network, and may be referred to as a g NodeB (gNB) or an NR NodeB (NR NB) in a 5G network. In some scenarios, the access network device may include a central unit (Central Unit, CU) and/or a distributed unit (Distributed Unit, DU). The CU and DU may be deployed in different places. For example, the DU is remotely deployed in a high-traffic area, and the CU is deployed in a central equipment room. Alternatively, the CU and the DU may be deployed in a same equipment room. The CU and the DU may alternatively be different components in a same rack. The network device may alternatively be a device that undertakes a base station function in device-to-device (Device-to-Device, D2D), vehicle-to-everything (vehicle-to-everything, V2X), or machine-to-machine (machine-to-machine, M2M) communication, or the like. For ease of description, in subsequent embodiments of this application, the foregoing apparatuses that provide the wireless communication function for the mobile terminal are collectively referred to as a network device. This is not specifically limited in embodiments of this application.

With development of wireless communication technologies, sensing, imaging, artificial intelligence/machine learning (Artificial Intelligence/Machine Learning, AI/ML) computing, and the like at a physical layer will become potential technologies and new application scenarios of future communication systems such as cellular and Wi-Fi. Future devices such as mobile terminals, sensors, and base stations can perform environment sensing and imaging by using electromagnetic signals, to perform offline or real-time modeling and analysis on wireless transmission environments, and finally significantly improve performance of the communication systems. Because a computing capability and a battery capacity of a single device and an environment range that can be sensed by the single device are limited, a result of sensing, imaging, or AI/ML computing may need to be sent to a remote central node (for example, a base station, a server, a cloud computing center, or a terminal device with strong computing power) in a backhaul manner for information fusion. Because applications such as applications for sensing, imaging, and integrated sensing and communication involve collection of a plurality of broadband frequencies, a larger-scale antenna array, and electromagnetic signals in different directions, a data amount of obtained signals is large. Therefore, a compression operation needs to be performed before wireless backhaul, to reduce consumption of wireless transmission resources. For AI/ML applications, processes such as model distribution and online training may also involve sending of a large amount of data. Therefore, compression processing also needs to be performed before transmission. However, there is currently no effective solution to meet requirements for higher accuracy and lower resource consumption.

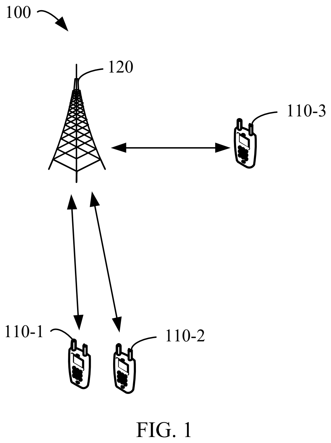

In view of this, embodiments of this application provide a communication method based on a dynamic dictionary. In the method, a first communication apparatus (for example, a terminal device or a network device) obtains training data used to determine dictionary update information, where the dictionary is used to perform data compression. The first communication apparatus determines a group of to-be-updated subsets in the dictionary based on the training data, and further determines the dictionary update information corresponding to the group of to-be-updated subsets. The first communication apparatus sends the dictionary update information to a communication apparatus communicating with the first communication apparatus. In this way, the first communication apparatus can efficiently perform dictionary update training, thereby reducing computing resources consumed by dictionary update, and saving wireless transmission resources needed for sending the dictionary update information. Therefore, accuracy of dictionary compression can be improved. The foregoing embodiments of this application are applicable to any other communication scenario. This is not limited. To describe embodiments of this application more clearly, embodiments of this application are described with reference to FIG. 1 to FIG. 11.

FIG. 1 is a diagram of a communication system 100 in which an embodiment of this application can be implemented. As shown in FIG. 1, the system 100 may include a first terminal device 110-1 to a third terminal device 110-3 (collectively referred to as terminal device 110) and a network device 120. The network device 120 and the terminal device 110 may directly communicate with each other. For example, the terminal device 110 may communicate with the corresponding network device 120 over a radio link.

It should be understood that quantities of terminal devices and network devices shown in FIG. 1 are merely used as examples. There may be more or fewer terminal devices and network devices. This is not limited in this application. In the following, a terminal device (or a chip in the terminal device) or a network device (or a chip in the network device) that performs dictionary update training to determine dictionary update training may be referred to as a first communication apparatus or may include a first communication apparatus, and a network device (or a chip in the network device) or a terminal device (or a chip in the terminal device) that receives dictionary update information to perform dictionary update may be referred to as a second communication apparatus or may include a second communication apparatus. In the following, some embodiments describe communication between a first communication apparatus and a second communication apparatus, and some embodiments describe communication between a terminal device and a network device. It should be understood that the communication is not limited to occurring between the terminal device and the network device, and may also occur between terminal devices, between network devices, or between any two or more communication devices in some scenarios. For example, a communication system may include a plurality of network devices, and the network devices may directly communicate with each other. For example, the network devices may communicate with each other over a backhaul (backhaul) link. The backhaul link may be a wired backhaul link (for example, an optical fiber or a copper cable), or may be a wireless backhaul link (for example, a microwave).

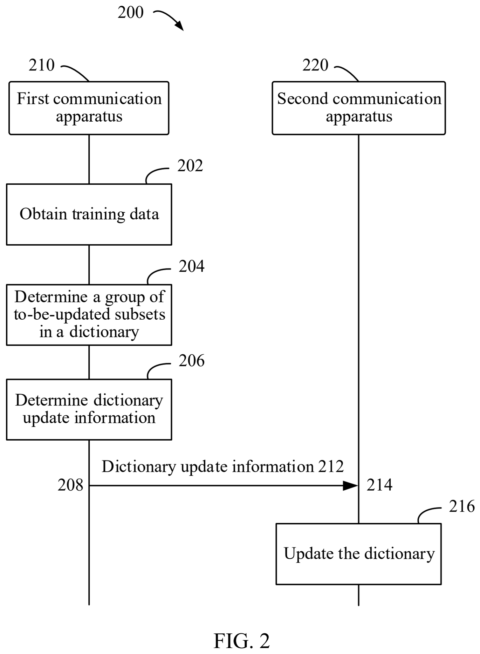

FIG. 2 is an interaction signaling diagram of a dictionary update method 200 according to some embodiments of this application. For clear description, the method 200 is described with reference to FIG. 1. A first communication apparatus 210 may be the terminal device 110 (or a chip of the terminal device 110) or the network device 120 (or a chip of the network device 120) in FIG. 1, and the second communication apparatus 220 may be the network device 120 (or the chip of the network device 120) or the terminal device 110 (or the chip of the terminal device 110) in FIG. 1.

Refer to FIG. 2. The first communication apparatus 210 obtains (202) training data. The training data is used to train a dictionary used for data compression. The term "dictionary" used in the present disclosure refers to a group of basic elements that can represent original data or signals in dictionary learning. The basic elements forming the dictionary may also be referred to as a dictionary subset. In some embodiments, when data compression is performed based on a given dictionary, a dictionary subset in the dictionary may be used to perform weighted representation on original data, to obtain a weighting coefficient corresponding to the dictionary subset. A sequence number of a dictionary subset corresponding to a weighting coefficient with a large absolute value and the corresponding weighting coefficient may be recorded, to compress the original data.

In some implementations, the dictionary may be a multidimensional matrix, for example, a two-dimensional matrix or a three-dimensional matrix, where a row vector, a column vector, or a submatrix in the multidimensional matrix is used as a dictionary subset. The dictionary may alternatively be a set including a plurality of matrixes or vectors, where the matrixes or the vectors that form the dictionary are used as dictionary subsets. The training data may be a row vector, a column vector, or a submatrix, and weighted representation may be performed on the training data by using a subset in the dictionary (for example, a row vector, a column vector, or a submatrix in the dictionary). In some implementations, the training data may be training data received by the first communication apparatus 210 from another communication apparatus. The another communication apparatus may be the second communication apparatus 220 or another communication apparatus that shares the dictionary with the first communication apparatus. In another implementation, the training data may be training data determined by the first communication apparatus 210.

The first communication apparatus 210 determines (204) a group of to-be-updated subsets in the dictionary based on the training data. In some implementations, the first communication apparatus 210 may determine a group of to-be-trained subsets in the dictionary based on the training data. The first communication apparatus 210 may perform dictionary update training on the to-be-trained subsets in the dictionary based on the training data, and determine a subset that meets a preset condition in the to-be-trained subsets as a to-be-updated subset. For example, the first communication apparatus 210 may determine an updated subset in the to-be-trained subsets as a to-be-updated subset. In another implementation, when a difference between an updated value and an initial value in a to-be-trained subset reaches a difference threshold, the first communication apparatus 210 may determine the to-be-trained subset as a to-be-updated subset. For example, the dictionary update training may be computed by using a K-singular value decomposition (K-singular value decomposition, K-SVD) algorithm.

The first communication apparatus 210 determines (206) dictionary update information 212 corresponding to the group of to-be-updated subsets. In some embodiments, the dictionary update information 212 may include indication information of a subset in the group of to-be-updated subsets and an update value for the subset in the group of to-be-updated subsets. For example, indication information of the to-be-updated subset may be implemented in a manner of an index or a bitmap. In some embodiments, the update value of the subset may be an updated value of the subset. In some embodiments, the update value of the subset may be a differential value between the updated value and an initial value that are of the subset.

The first communication apparatus 210 sends (208) the dictionary update information 212 to the second communication apparatus 220. In some embodiments, the first communication apparatus 210 may be the terminal device 110 in FIG. 1, and the second communication apparatus 220 may be the network device 210 in FIG. 2. In this case, the terminal device 110 may perform a dictionary update operation, and send the dictionary update information 212 to the network device 210 over an uplink channel. In another embodiment, the first communication apparatus 210 may be the network device 210 in FIG. 1, and the second communication apparatus 220 may be the terminal device 110 in FIG. 2. In this case, the network device 210 may perform a dictionary update operation, and send the dictionary update information 212 to the terminal device 110 over a downlink channel.

The second communication apparatus 220 receives (214) the dictionary update information 212 from the first communication apparatus 210. After receiving the dictionary update information 212, the second communication apparatus 220 updates (216) the dictionary based on the dictionary update information 212. In this way, the first communication apparatus 210 and the second communication apparatus 220 share an updated dictionary. In a dictionary update manner in this embodiment of this application, only some subsets in the dictionary are selected for update training each time, and only information about a dictionary subset that needs to be updated is sent. Therefore, computing resources consumed by dictionary update and wireless transmission resources needed for sending the dictionary update information can be reduced. Because the dictionary update can be performed efficiently, data compression performance can be improved.

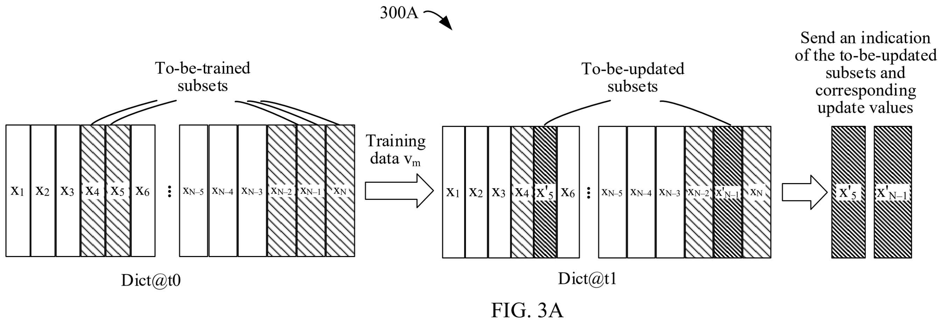

FIG. 3A is a diagram of an example implementation of a method 300A for determining dictionary update information according to some embodiments of this application. The method 300A is described with reference to FIG. 2. The method 300A may be performed by the first communication apparatus 210 in FIG. 2.

In the method 300A, the first communication apparatus 210 stores a dictionary (for example, Dict@t0 in FIG. 3A) used for data compression. The dictionary Dict@t0 may be a two-dimensional matrix including column vectors $x_{ind}$ (N×1 dimensions). The first communication apparatus 210 may update the dictionary based on training data $v_m$ (m=1, 2, ..., M). It should be understood that the dictionary in FIG. 3A is merely an example, and is not intended to be limiting. The dictionary may be implemented as a multidimensional matrix (for example, a two-dimensional matrix or a three-dimensional matrix) including column vectors, row vectors, or submatrixes, where a row vector, a column vector, or a submatrix in the multidimensional matrix is used as a dictionary subset. The dictionary may alternatively be implemented as a set including a plurality of matrixes or vectors, where the matrixes or the vectors that form the dictionary are used as dictionary subsets.

First, for each piece of training data $v_m$ (m=1, 2, ..., M), the first communication apparatus 210 may select K column vectors from the dictionary Dict@t0 as a to-be-trained subset. The selected K column vectors may be vectors that can represent the training data $v_m$ most closely in a weighting manner. For example, the training data $v_m$ may be approximately represented as $v_m \approx \sum_{mk=1}^{K} w_{ind_{mk}} \mathbf{x}_{ind_{mk}}$, where $\mathbf{x}_{indmk}$ represents a $k^{th}$ weighting vector used for weighted representation of

the training data $v_m$, $w_{indmk}$ represents a weighting coefficient corresponding to the $k^{th}$ weighting vector $\mathbf{x}_{indmk}$ used for the weighted representation of the training data $v_m$, and $ind_{mk}$ represents a column sequence number of the vector $\mathbf{x}_{indmk}$ in the dictionary Dict@t0. K may be a preconfigured dictionary compression parameter. A set of column sequence numbers of the K weighting vectors corresponding to the training data $v_m$ in the dictionary Dict@t0 may be represented as $I_m=\{ind_{m1}, ind_{m2}, ..., ind_{mK}\}$.

The first communication apparatus 210 may combine sets of column sequence numbers corresponding to all the training data, to obtain a column sequence number set $I=I_1\cup I_2\cup...\cup I_M$. The first communication apparatus 210 may perform an update operation only on to-be-trained subsets corresponding to the column sequence number set I, to obtain an updated dictionary Dict@t1. When dictionary update training is performed, a classical K-SVD algorithm may be used. The update operation is performed only on the to-be-trained subsets in the to-be-trained subset set I, so that an update operation amount can be reduced.

In some implementations, the first communication apparatus 210 may determine, as a to-be-updated subset, a dictionary subset $\mathbf{x}'_{indmk}$ that changes in the dictionary subsets corresponding to the set I. In another implementation, the first communication apparatus 210 may determine a differential value between an updated value $\mathbf{x}'_{indmk}$ and an initial value $\mathbf{x}_{indmx}$ that are of a dictionary subset that changes in the dictionary subsets corresponding to the set I, and determine a subset whose differential value is greater than a threshold as a to-be-updated subset. In some implementations, the differential value may be a 1-norm or a 2-norm of a difference between the updated value $\mathbf{x}'_{indmk}$ and the initial value $\mathbf{x}_{indmk}$ that are of the dictionary subset, or another value indicating the difference.

Return to FIG. 2. The first communication apparatus 210 may send dictionary update information to the second communication apparatus 220, where the dictionary update information may include an indication of to-be-updated subsets and corresponding update values. For example, the update value of the to-be-updated subset may be an updated value of the to-be-updated subset. Alternatively, the update value of the to-be-updated subset may be a differential value between the updated value and an initial value that are of the to-be-updated subset.

In some implementations, the first communication apparatus 210 may directly send the dictionary update information to the second communication apparatus 220. In another implementation, to further reduce bandwidth resource consumption, the first communication apparatus 210 may compress the dictionary update information, and send the compressed dictionary update information to the second communication apparatus 220. For example, the dictionary update information 212 may include the update value compressed based on the compression control information. In other words, the update value of the subset may be compressed based on the compression control information before being sent. The compression control information may include at least one of the following: a quantization mode, a quantization bit quantity, a transform mode, or an entropy coding mode.

In some embodiments, the first communication apparatus 210 may determine the compression control information, and send the compression control information to the second communication apparatus 220. In this way, the second communication apparatus 220 can decompress the dictionary update information.

In some embodiments, the second communication apparatus 220 may determine the compression control information, and send the compression control information to the first communication apparatus 210. In this way, the second communication apparatus 220 can decompress the dictionary update information.

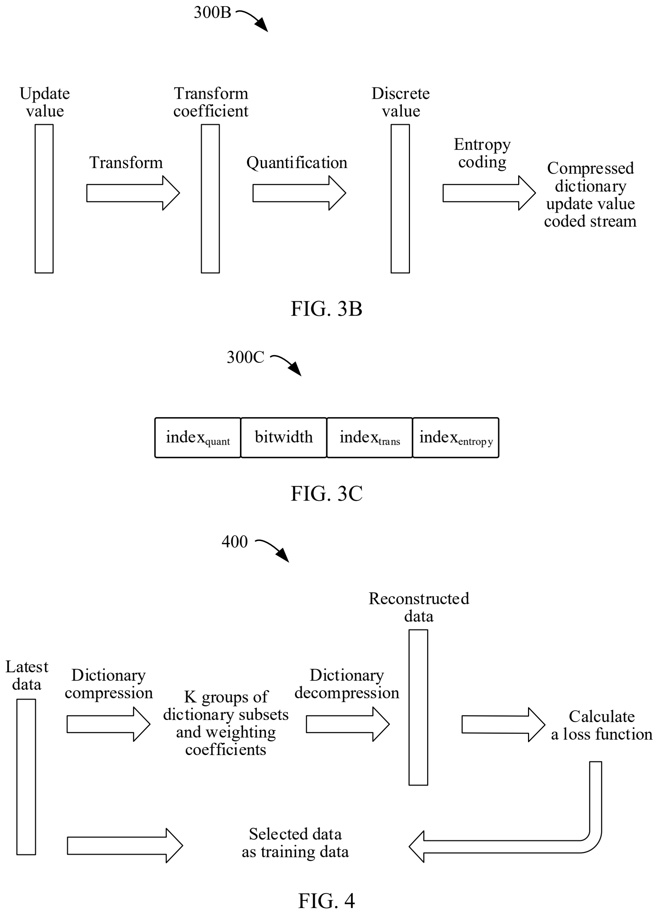

FIG. 3B is a diagram of an example implementation of a method 300B for compressing a dictionary update value according to some embodiments of this application. The method 300B is described with reference to FIG. 2. The method 300B may be performed by the first communication apparatus 210 in FIG. 2.

In the method 300B, the first communication apparatus 210 may perform transform such as DFT, DCT, or DWT or other predefined transform on update values of to-be-updated subsets of a dictionary, to obtain corresponding transform coefficients. The first communication apparatus 210 may perform quantization on the transform coefficients to obtain corresponding discrete values. For a complex signal, the first communication apparatus 210 may separately perform quantization on a real part and an imaginary part of the complex signal. Alternatively, the first communication apparatus 210 may separately perform quantization on an amplitude and a phase of the complex signal. For a real-number signal, the first communication apparatus 210 may directly perform quantization on the real-number signal. In some implementations, the quantization may be uniform quantization. In some implementations, the quantization may be non-uniform quantization. For different dictionaries, the first communication apparatus 210 may process, by using different quantization orders, transform coefficients corresponding to dictionary update values. The first communication apparatus 210 may perform entropy coding (for example, but not limited to arithmetic coding and Huffman coding) on the discrete values, to obtain a compressed dictionary update value coded stream.

In this way, the first communication apparatus 210 can efficiently compress dictionary update values, so that the second communication apparatus 220 that shares the dictionary with the first communication apparatus 210 can obtain accurate dictionary update information, thereby improving accuracy of dictionary compression. Because only update values of some subsets of the dictionary need to be compressed and sent, the dictionary update values compressed in the entropy coding manner consume fewer transmission resources.

The first communication apparatus 210 may perform, based on a compression control parameter, the method 300B for compressing a dictionary update value. In some embodiments, the compression control parameter may include a quantization mode, a quantization bit quantity, a transform mode, an entropy coding mode, or the like. The second communication apparatus 220 may decompress the dictionary update information based on a same compression control parameter, to update the dictionary based on the dictionary update values. In some implementations, the first communication apparatus 210 may determine the compression control parameter, and send compression control information including the compression control parameter to the second communication apparatus 220. In another implementation, the second communication apparatus 220 may determine the compression control parameter, and send compression control information including the compression control parameter to the first communication apparatus 210. Therefore, the plurality of communication apparatuses sharing the dictionary can complete configuration of the compression control parameter. When the terminal device 110 in FIG. 1 determines the compression control parameter, the terminal device 110 may send the compression control information to the network device 120 over an uplink channel. When the network device 120 in FIG. 1 determines the compression control parameter, the network device 120 may send the compression control information to the terminal device 110 via radio resource control (Radio Resource Control, RRC) signaling, medium access control (Medium Access Control, MAC) signaling, or physical downlink control channel (Physical Downlink Control Channel, PDCCH) signaling.

FIG. 3C is a diagram of an example implementation of compression control information 300C according to some embodiments of this application. The compression control information 300C may include an indication of a quantization mode, an indication of a quantization bit quantity, an indication of a transform mode, an indication of an entropy coding mode, or the like. For example, in some implementations, the first communication apparatus 210 and the second communication apparatus 220 may each store a group of quantization mode configurations. The compression control information 300C may include an index $index_{quant}$ of the quantization mode. Similarly, in some implementations, the compression control information 300C may include an index $index_{trans}$ of the transform mode. In some implementations, the compression control information 300C may further include an index $index_{entropy}$ of the entropy coding mode. In this way, transmission resources consumed for sending the compression control information can be reduced. It should be understood that the compression control information 300C shown in FIG. 3C is merely an example, and is not intended to be limiting. In some embodiments, at least one of the quantization mode, the quantization bit quantity, the transform mode, or the entropy coding mode may be predetermined, and therefore does not need to be included in the compression control information 300C. In some embodiments, the dictionary update values may alternatively be compressed in another compression mode.

Return to FIG. 2. In some implementations, to obtain training data, the first communication apparatus 210 may select the training data from data to be sent to the second communication apparatus 220, determine a to-be-updated subset in a dictionary based on the selected training data, and further determine dictionary update information. For example, the first communication apparatus 210 may perform dictionary compression on the to-be-sent data based on the dictionary, to obtain dictionary compressed data. The first communication apparatus 210 may decompress the obtained dictionary compressed data based on the dictionary to obtain reconstructed data. The first communication apparatus 210 may determine a loss function of the reconstructed data based on the to-be-sent data. Further, the first communication apparatus 210 may determine the training data based on the loss function of the reconstructed data. For example, the first communication apparatus 210 may determine, based on determining that the loss function of the reconstructed data reaches a loss function threshold, the to-be-sent data as being included in the training data. In another example, the first communication apparatus 210 may sort a plurality of pieces of to-be-sent data based on loss functions of reconstructed data corresponding to data in the plurality of pieces of to-be-sent data. The first communication apparatus 210 may select training data from the plurality of pieces of to-be-sent data based on the sorting. The first communication apparatus 210 may determine a to-be-updated subset in the dictionary based on the determined training data, and further determine dictionary update information.

In some implementations, to obtain training data, the second communication apparatus 220 may select the training data from data to be sent to the first communication apparatus 210, and send the training data to the first communication apparatus 210. The first communication apparatus 210 may determine a to-be-updated subset in a dictionary based on the received training data, and further determine dictionary update information. For example, the second communication apparatus 220 may perform data compression (for example, perform efficient compression in the entropy coding mode) on the selected training data based on a compression control parameter. The first communication apparatus 210 may receive, from the second communication apparatus 220, compressed data corresponding to the training data, and decompress the received compressed data based on the same compression control parameter, to obtain the training data. The compression control parameter may be at least one of the following: a quantization mode, a quantization bit quantity, a transform mode, an entropy coding mode, or the like.

FIG. 4 is a diagram of an example implementation of a method 400 for selecting training data according to some embodiments of this application. The method 400 is described with reference to FIG. 1 and FIG. 2. The method 400 may be performed by the terminal device 110 in FIG. 1, the network device 120 in FIG. 1, the first communication apparatus 210 in FIG. 2, or the second communication apparatus 220 in FIG. 2. For example, in an example application scenario, the terminal device 110 may obtain channel state information (channel state information, CSI) associated with the network device 120. The terminal device 110 and the network device 120 may share a dictionary corresponding to the CSI. For example, the terminal device 110 may compress the CSI based on the dictionary, and send the CSI on which the dictionary compression is performed to the network device 120. Correspondingly, the network device 120 may decompress the received CSI based on the same dictionary. Considering that the network device 120 has a stronger computing capability and a looser power consumption limit, the network device 120 may perform dictionary training or update. In this case, the terminal device 110 needs to select training data from the obtained CSI, and send the training data to the network device 120 over an uplink channel.

The following describes the method 400 by using an example in which the terminal device 110 selects training data. The terminal device 110 may obtain latest data to be sent to the network device 120. The terminal device 110 needs to send only a part of the data to be sent to the network device 120, to use the part of the data as data for online dictionary training. It should be understood that the method 400 may alternatively be performed by another device or communication apparatus.

As shown in FIG. 4, the terminal device 110 performs dictionary compression on each piece of latest to-be-sent data $v$ by using a conventional dictionary, to obtain dictionary compressed data. The dictionary compressed data includes K groups of dictionary subsets and corresponding weighting coefficients, and K may be a preconfigured dictionary compression parameter. The K groups of dictionary subsets and the corresponding weighting coefficients can represent the to-be-sent data most closely in a weighting manner.

The terminal device 110 may perform dictionary decompression on the dictionary compressed data based on the dictionary, to obtain reconstructed data $v'$. The terminal device 110 may evaluate a loss function of the reconstructed data $v'$ relative to the original to-be-sent data $v$. For example, a loss function like a normalized mean square error (Normalized Mean Square Error, NMSE$= \|v - v'\|^2/\|v\|^2$) or a generalized cosine similarity (Generalized Cosine Similarity, GCS$=v * v'^H/(\|v\| * \|v'\|)$) may be used.

The terminal device 110 may determine, according to a predefined rule, whether corresponding data can be used for dictionary update training. For example, in some implementations, the terminal device 110 may select data whose NMSE is greater than a preset threshold or whose GCS is less than a preset threshold as training data. In another implementation, the terminal device 110 may sort NMSEs or GCSs of all to-be-sent data, and select, from all the to-be-sent data based on a preset amount or a preset percentage, several pieces of data with highest NMSEs or lowest GCSs as training data. In some implementations, the network device 120 may determine a training data selection rule and a corresponding parameter (for example, a preset threshold of a loss function, or an amount or a percentage of training data selected based on sorting), and send corresponding configuration information to the terminal device 110. In another implementation, the terminal device 110 may independently determine a training data selection rule and a corresponding parameter.

The terminal device 110 may send the training data to the network device 120 over the uplink channel. To save bandwidth resources, the terminal device 110 may compress the training data by using a method similar to the method 300B described with reference to FIG. 3B. A compression control parameter used to compress the training data may include a quantization mode, a quantization bit quantity, a transform mode, an entropy coding mode, or the like. In some embodiments, the compression control parameter may be the same as a compression control parameter in the compression control information 300C shown in FIG. 3C. In other words, the compression control parameter in the compression control information 300C shown in FIG. 3C may be used to compress the training data and dictionary update information. In another embodiment, the compression control parameter used to compress the training data may be different from the compression control parameter in the compression control information 300C shown in FIG. 3C. For example, the compression control parameter used to compress the training data may be configured by the terminal device 110, or may be configured by the network device 120. For example, the compression control parameter used to compress the training data may be configured by using indication information received from the network device 120.

In some implementations, training data used for dictionary update may be referred to as incremental training data. In other words, the incremental training data is data newly obtained by a communication apparatus in a current environment, and is used to perform online dictionary update on a generated dictionary. The communication apparatus may periodically obtain an incremental training data set. If the second communication apparatus 220 obtains the training data, and the first communication apparatus 210 performs dictionary update training to determine the dictionary update information, the second communication apparatus 220 may send an incremental training data set to the first communication apparatus 210.

In some implementations, a dictionary may be generated based on a basic training data set, and the basic training data set may be selected from at least one predetermined basic training data set. Considering that the network device 120 has a stronger computing capability and a looser power consumption limit, the network device 120 may generate a dictionary based on the basic training data set. For example, the network device 120 may store a group of basic training data sets. The group of basic training data sets may include at least one basic training data set prespecified in a protocol, and each basic training data set is used to perform dictionary initialization training for a corresponding communication scenario or environment. In some implementations, the network device 120 may select an applicable basic training data set from the group of stored basic training data sets based on, for example, a specific application or scenario, to perform dictionary initialization training, to generate a dictionary. The network device 120 may send the generated dictionary to the terminal device 110.

In some implementations, the network device 120 may perform dictionary initialization training based on a group of basic training data sets, to generate a group of dictionaries. The network device 120 may select an applicable dictionary from a group of stored dictionaries based on, for example, a specific application or scenario, and send the selected dictionary to the terminal device 110.

In some implementations, the network device 120 may perform dictionary initialization training based on a group of basic training data sets. The network device 120 may send a group of generated dictionaries to the terminal device 110. One of the network device 120 and the terminal device 110 may select an applicable dictionary based on a specific application or scenario, and send an indication of the selected dictionary to the other. It may be understood that the indication may be implemented in an explicit indication manner or an implicit indication manner. In some embodiments, one of the network device network device 120 and the terminal device 110 may select an applicable dictionary based on a specific application or scenario, and send the selected dictionary to the other. In some embodiments, the network device 120 and the terminal device 110 may select an applicable dictionary according to a predefined rule and based on a specific application or scenario. Therefore, the network device 120 and the terminal 110 can share the dictionary.

In some implementations, to obtain training data, the first communication apparatus 210 may periodically receive training data from the second communication apparatus 220, to periodically perform dictionary update training. In another embodiment, the first communication apparatus 210 may periodically perform dictionary update training based on training data determined by the first communication apparatus 210.

In some embodiments, the first communication apparatus 210 may be implemented by the network device 120 in FIG. 1 or the chip of the network device 120, and the second communication apparatus 220 may be implemented by the terminal device 110 in FIG. 1 or the chip of the terminal device 110. The terminal device 110 may periodically send training data to the network device 120, so that the network device 120 performs dictionary update training on a corresponding dictionary.

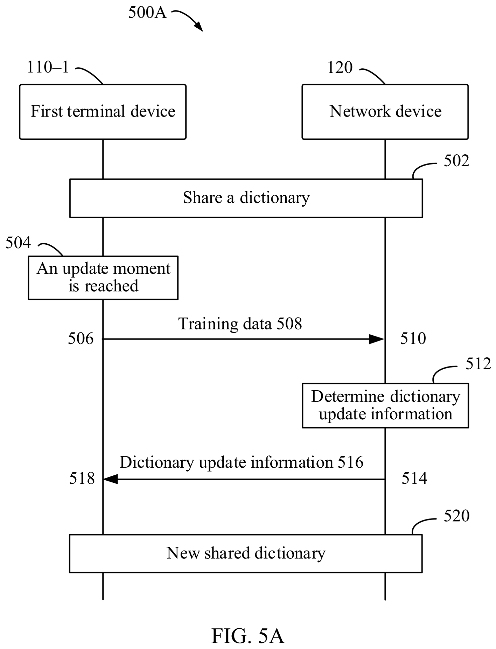

FIG. 5A is a diagram of an example implementation of a method 500A for periodically updating a dictionary according to some embodiments of this application. For clear description, the method 500A is described with reference to FIG. 1. The method 500A may relate to the first terminal device 110-1 and the network device 120.

Refer to FIG. 5A. The first terminal device 110-1 and the network device 120 may share (502) a dictionary corresponding to data (for example, CSI). The first terminal device 110-1 may determine (504) that a dictionary update moment arrives. The first terminal device 110-1 may send (506) training data 508 to the network device 120 via a reserved transmission resource. The network device 120 may receive (510) the training data 508 from the first terminal device 110-1. The network device 120 may determine (512) dictionary update information 516 based on the training data 508.

The network device 120 may send (514) the dictionary update information 516 to the first terminal device 110-1. For example, a transmission resource for sending the dictionary update information 516 may be reserved. The first terminal device 110-1 may receive (518) the dictionary update information 516 from the network device 120. The network device 120 and the first terminal device 110-1 may share (520) a new dictionary. Therefore, the network device 120 and the first terminal device 110-1 may perform data compression and decompression based on the new dictionary. In this way, signaling overheads can be reduced.

In some implementations, the second communication apparatus 220 may send a resource request to the first communication apparatus 210 based on a predetermined trigger condition for sending the training data being met. The first communication apparatus 210 may send a resource allocation indication to the second communication apparatus 220 based on the resource request received from the second communication apparatus 220. The second communication apparatus 220 may send the training data to the first communication apparatus 210 based on the resource allocation indication. In another embodiment, the first communication apparatus 210 may perform dictionary update training based on a predetermined dictionary update training trigger condition being met.

In some embodiments, the first communication apparatus 210 may be implemented by the network device 120 in FIG. 1 or the chip of the network device 120, and the second communication apparatus 220 may be implemented by the terminal device 110 in FIG. 1 or the chip of the terminal device 110. The terminal device 110 may send a resource request to the network device 120 based on a trigger condition being met, to request a resource used to send the training data.

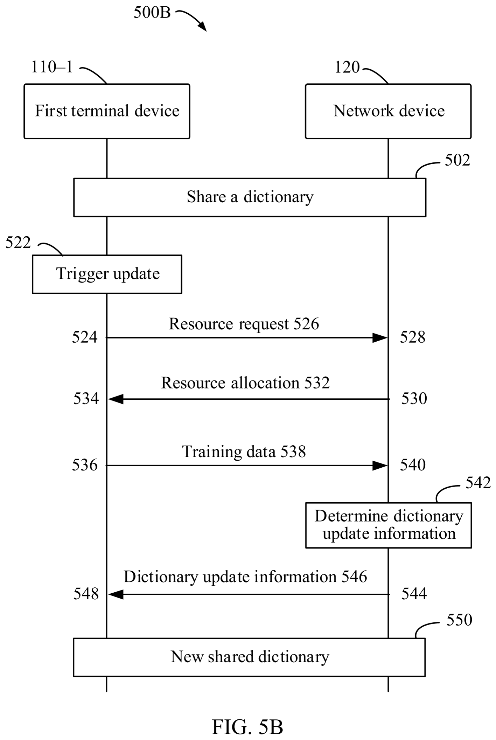

FIG. 5B is a diagram of an example implementation of a method 500B for aperiodically updating a dictionary according to some embodiments of this application. For clear description, the method 500B is described with reference to FIG. 1. The method 500B may relate to the first terminal device 110-1 and the network device 120.

The first terminal device 110-1 and the network device 120 may share (502) a dictionary corresponding to data (for example, CSI). The first terminal device 110-1 triggers (522) a dictionary update operation based on determining that a dictionary update trigger condition is met. For example, the first terminal device 110-1 may estimate an NMSE or a GCS obtained through dictionary compression and decompression performed on each piece of data to be sent to the network device 120. When an NMSE of one or more pieces of to-be-sent data (for example, a predetermined amount of to-be-sent data or a predetermined percentage of to-be-sent data) is greater than a specified threshold or a GCS of the one or more pieces of to-be-sent data is less than a specified threshold, the dictionary update operation may be triggered.

The first terminal device 110-1 may send (524) a resource request 526 to the network device 120. The network device 120 may receive (528) the resource request 526 from the first terminal device 110-1. The network device 120 may send (530) a resource allocation indication 532 to the first terminal device 110-1. The first terminal device 110-1 may receive (534) the resource allocation indication 532 from the network device 120.

The first terminal device 110-1 may send (536) training data 538 to the network device 120 based on the resource allocation indication 532. The network device 120 may receive (540) the training data 538 from the first terminal device 110-1. The network device 120 may determine (542) dictionary update information 546 based on the training data 538.

The network device 120 may send (544) the dictionary update information 546 to the first terminal device 110-1. The first terminal device 110-1 may receive (548) the dictionary update information 546 from the network device 120. The network device 120 and the first terminal device 110-1 may share (550) a new dictionary. Therefore, the network device 120 and the first terminal device 110-1 may perform data compression and decompression based on the new dictionary. In this way, accuracy of dictionary compression can be improved while an operation amount is reduced.

In some implementations, a first communication apparatus, a second communication apparatus, and a third communication apparatus may share a same dictionary. When sending dictionary update information, the first communication apparatus may send the dictionary update information to the second communication apparatus and the third communication apparatus. In other words, communication apparatuses that share a same dictionary may synchronously send training data to a communication apparatus that is configured to perform dictionary update training. For example, the first communication apparatus may be implemented by the network device 120 or the chip of the network device 120 in FIG. 1, and the second communication apparatus and the third communication apparatus may be implemented by the terminal device 110 or the chip of the terminal device 110 in FIG. 1. For example, the terminal devices 110 served by the same network device 120 may share a same dictionary. In some implementations, a group of communication apparatuses may share a same dictionary. When sending the dictionary update information, the first communication apparatus may send the dictionary update information to communication apparatuses in a same group. For example, the terminal devices 110 served by the same network device 120 may be divided into a plurality of groups. Terminal devices in each group may share a same dictionary. The first terminal device 110-1 and the second terminal device 110-2 in FIG. 1 may be included in a same group, and the third terminal device 110-3 may be included in another group. The second communication apparatus may be implemented by the first terminal device 110-1 or a chip of the first terminal device 110-1 in FIG. 1, and the third communication apparatus may be implemented by the second terminal device 110-2 or a chip of the second terminal device 110-2 in FIG. 1.

In some implementations, the first terminal device 110-1 and the second terminal device 110-2 may periodically send training data to the network device 120, so that the network device 120 performs dictionary update training on a corresponding dictionary. The training data received by the network device 120 may include training data received from the first terminal device 110-1 and training data received from the second terminal device 110-2.

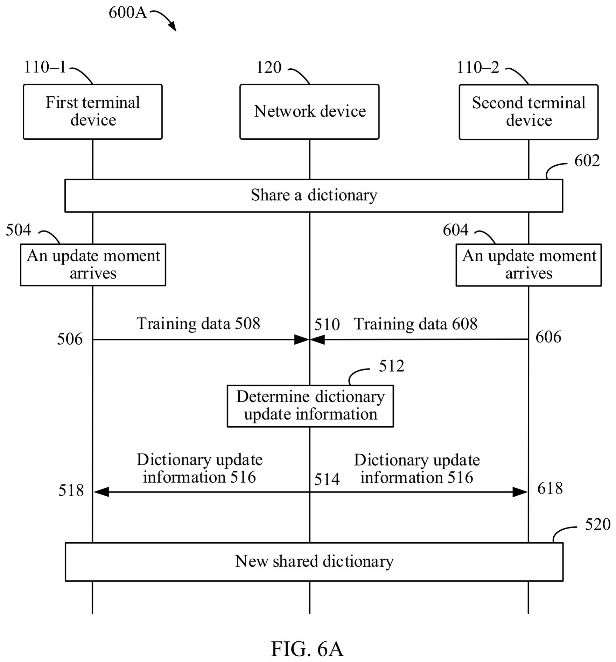

FIG. 6A is a diagram of an example implementation of a method 600A for periodically updating a dictionary according to some embodiments of this application. For clear description, the method 600A is described with reference to FIG. 1. The method 600A may relate to the first terminal device 110-1, the second terminal device 110-2, and the network device 120. The method 600A may be considered as a specific implementation of the method 500A shown in FIG. 5A. Same reference numerals indicate same steps or elements, and detailed descriptions thereof are omitted.

The first terminal device 110-1, the second terminal device 110-2, and the network device 120 may share (602) a dictionary corresponding to data. For example, the data may be CSI. The first terminal device 110-1 and the second terminal device 110-2 are at similar geographical locations and are in similar channel state environments. Therefore, the network device 120 determines that the first terminal device 110-1 and the second terminal device 110-2 are in a same group. In another implementation, all terminal devices served by the network device 120 may share a same dictionary.

The second terminal device 110-2 may determine (604) that a dictionary update moment arrives. In some implementations, step 604 and step 504 are simultaneously performed. The second terminal device 110-2 may send (606) training data 608 to the network device 120 via a reserved transmission resource. In some implementations, step 606 and step 506 are simultaneously performed. The network device 120 may receive (510) the training data 508 and the training data 608 from the first terminal device 110-1 and the second terminal device 110-2 respectively. The network device 120 may determine (512) the dictionary update information 516 based on the training data 508 and the training data 608. In some implementations, the network device 120 may determine the dictionary update information 516 based on training data received from all the terminal devices served by the network device 120. In another implementation, the network device 120 may determine the dictionary update information 516 based on training data received from terminal devices included in a same group.

The network device 120 may send (514) the dictionary update information 516 to the first terminal device 110-1 and the second terminal device 110-2. In some implementations, the network device 120 may send, in a broadcast manner, the dictionary update information 516 to all the terminal devices served by the network device 120. In another implementation, the network device 120 may send, in a multicast manner, the dictionary update information 516 to terminal devices in a same group.

The second terminal device 110-2 may receive (618) the dictionary update information 516 from the network device 120. In some implementations, step 618 and step 518 are simultaneously performed. The network device 120, the first terminal device 110-1, and the second terminal device 110-2 may share (520) a new dictionary. Therefore, the network device 120, the first terminal device 110-1, and the second terminal device 110-2 may perform data compression and decompression based on the new dictionary. In this way, signaling overheads can be reduced.

In some embodiments, a second communication apparatus and a third communication apparatus may communicate with each other over a sidelink. For example, the second communication apparatus may select, from a first data set obtained by the second communication apparatus, a first training data set to be sent to a first communication apparatus. The third communication apparatus may select, from a second data set obtained by the third communication apparatus, a second training data set to be sent to the first communication apparatus. The second communication apparatus may send the first training data set to the third communication apparatus. The third communication apparatus may update the second training data set based on the first training data set. For example, the third communication apparatus may filter out data that is in the second training data set and that is the same as that in the first training data set. For example, the third communication apparatus may filter out data that is in the second training data set and that is related to the first training data set. In another example, the third communication apparatus may first receive the first training data set, and then select, from the second data set obtained by the third communication apparatus, the second training data set to be sent to the first communication apparatus, to reduce correlation between the second training data set and the first training data set. In this way, a transmission resource needed for sending the training data by the third communication apparatus to the first communication apparatus can be saved, and an operation amount of performing a dictionary update operation by the first communication apparatus can be reduced.

For example, the first terminal device 110-1 and the second terminal device 110-2 may communicate with each other over a sidelink. Before sending the training data 608 to a network device 510, the second terminal device 110-2 may first receive training data from the first terminal device 110-1. The training data may be some feature information of the training data 508. Alternatively, the training data may be a subset of the training data 508 or may be the training data 508. The second terminal device 110-2 may screen the training data 608 based on the training data received from the first terminal device 110-1, select training data completely irrelevant to the training data received from the first terminal device 110-1, and send the selected training data to the network device 120, for the network device 120 to perform a subsequent dictionary update operation. In this way, transmission resources needed for sending the training data by the second terminal device 110-2 can be reduced.

In some implementations, at least one of the second communication apparatus and the third communication apparatus may send a resource request to the first communication apparatus based on a predetermined trigger condition for sending training data being met. The first communication apparatus may send a resource allocation indication to at least one of the second communication apparatus and the third communication apparatus based on the resource request received from at least one of the second communication apparatus and the third communication apparatus. At least one of the second communication apparatus and the third communication apparatus may send the training data to the first communication apparatus based on the resource allocation indication. In other words, the second communication apparatus and the third communication apparatus that share a same dictionary may asynchronously send the training data to the first communication apparatus. In another embodiment, the first communication apparatus 210 may perform dictionary update training based on a predetermined dictionary update training trigger condition being met.

In some embodiments, the first terminal device 110-1 and the second terminal device 110-2 may periodically send training data to the network device 120, so that the network device 120 performs dictionary update training on a corresponding dictionary. The training data received by the network device 120 may include training data received from the first terminal device 110-1 and training data received from the second terminal device 110-2.

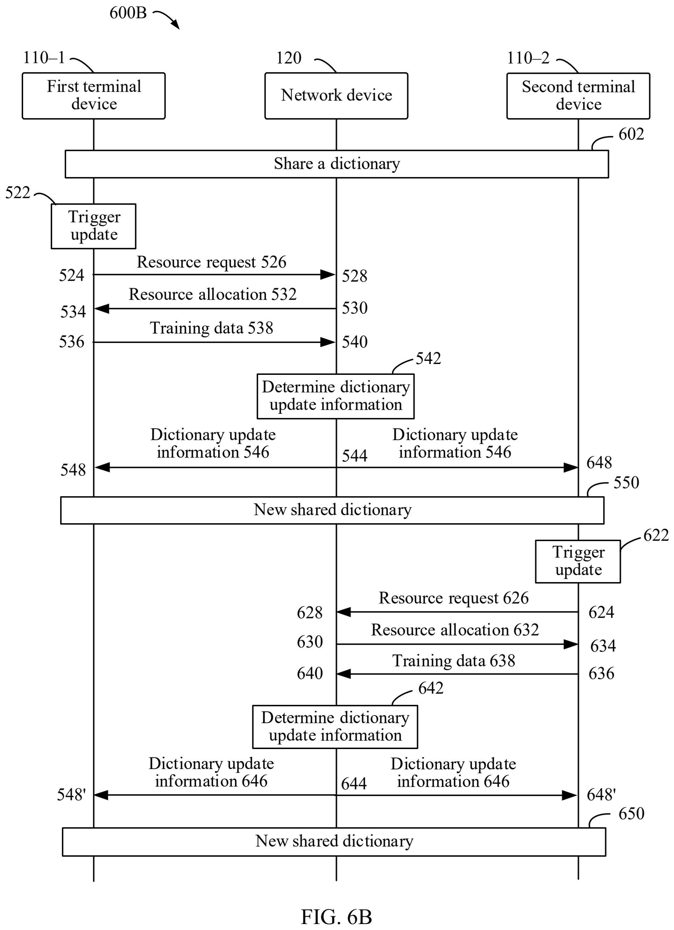

FIG. 6B is a diagram of an example implementation of a method 600B for aperiodically updating a dictionary according to some embodiments of this application. For clear description, the method 600B is described with reference to FIG. 1. The method 600B may relate to the first terminal device 110-1, the second terminal device 110-2, and the network device 120. The method 600B may be considered as a specific implementation of the method 500B shown in FIG. 5B. Same reference numerals indicate same steps or elements, and detailed descriptions thereof are omitted.

The first terminal device 110-1, the second terminal device 110-2, and the network device 120 may share (502) a dictionary corresponding to data (for example, CSI). The first terminal device 110-1 and the second terminal device 110-2 are at similar geographical locations and are in similar channel state environments. Therefore, the network device 120 determines that the first terminal device 110-1 and the second terminal device 110-2 are in a same group. In another implementation, all terminal devices served by the network device 120 may share a same dictionary.

The network device 120 may send (544) the dictionary update information 546 to the first terminal device 110-1 and the second terminal device 110-2. In some implementations, the network device 120 may send, in a broadcast manner, the dictionary update information 546 to all the terminal devices served by the network device 120. In another implementation, the network device 120 may send, in a multicast manner, the dictionary update information 546 to terminal devices in a same group.

The second terminal device 110-2 may receive (648) the dictionary update information 546 from the network device 120. In some implementations, step 648 and step 548 are simultaneously performed. The network device 120, the second terminal device 110-2, and the first terminal device 110-1 may share (550) a new dictionary. Therefore, the network device 120, the first terminal device 110-1, and the second terminal device 110-2 may perform data compression and decompression based on the new dictionary.

The second terminal device 110-2 may trigger (622) a dictionary update operation based on determining that a dictionary update trigger condition is met. For example, the second terminal device 110-2 may estimate an NMSE or a GCS obtained through dictionary compression and decompression performed on each piece of data to be sent to the network device 120. When an NMSE of one or more pieces of to-be-sent data (for example, a predetermined amount of to-be-sent data or a predetermined percentage of to-be-sent data) is greater than a specified threshold or a GCS of the one or more pieces of to-be-sent data is less than a specified threshold, the dictionary update operation may be triggered. In some embodiments, dictionary update trigger conditions of the first terminal device 110-1 and the second terminal device 110-2 may be the same. In some embodiments, dictionary update trigger conditions of the first terminal device 110-1 and the second terminal device 110-2 may be different.

The second terminal device 110-2 may send (624) a resource request 626 to the network device 120. The network device 120 may receive (628) the resource request 626 from the second terminal device 110-2. The network device 120 may send (630) a resource allocation indication 632 to the second terminal device 110-2. The second terminal device 110-2 may receive (634) the resource allocation indication 632 from the network device 120. The second terminal device 110-2 may send (636) training data 638 to the network device 120 based on the resource allocation indication 632.

The network device 120 may receive (640) the training data 638 from the second terminal device 110-2. The network device 120 may determine (642) dictionary update information 646 based on the training data 638. The network device 120 may send (644) the dictionary update information 646 to the first terminal device 110-1 and the second terminal device 110-2. In some implementations, the network device 120 may send, in a broadcast manner, the dictionary update information 646 to all the terminal devices served by the network device 120. In another implementation, the network device 120 may send, in a multicast manner, the dictionary update information 646 to terminal devices in a same group.

The first terminal device 110-1 may receive (548') the dictionary update information 646 from the network device 120. The first terminal device 110-1 may receive (648') the dictionary update information 646 from the network device 120. In some implementations, step 648' and step 548' are simultaneously performed. The network device 120, the first terminal device 110-1, and the second terminal device 110-2 may share (650) a new dictionary. Therefore, the network device 120, the first terminal device 110-1, and the second terminal device 110-2 may perform data compression and decompression based on the new dictionary. In this way, accuracy of dictionary compression can be improved while an operation amount is reduced.

In some implementations, when a first communication apparatus sends multidimensional data to a second communication apparatus, the first communication apparatus may compress the multidimensional data based on a plurality of dictionaries, and send the compressed data to the second communication data. The second communication apparatus may decompress the received compressed data based on the same plurality of dictionaries, to obtain the multidimensional data. Alternatively or additionally, when the second communication apparatus sends multidimensional data to the first communication apparatus, the second communication apparatus may compress the multidimensional data based on a plurality of dictionaries, and send the compressed data to the first communication data. The first communication apparatus may decompress the received compressed data based on the same plurality of dictionaries, to obtain the multidimensional data.

In some implementations, a communication apparatus that stores a plurality of dictionaries performs a dimension reduction operation on a to-be-sent multidimensional data matrix, to obtain a plurality of groups of low-dimensional data. In some embodiments, the plurality of dictionaries respectively correspond to the plurality of groups of low-dimensional data. For example, the low-dimensional data may be represented by a one-dimensional vector. The communication apparatus may perform dictionary compression on the plurality of groups of low-dimensional data based on the plurality of dictionaries, and send the plurality of groups of low-dimensional data on which the dictionary compression is performed.

In some implementations, a communication apparatus may receive a plurality of groups of low-dimensional data on which dictionary compression is performed. The communication apparatus may perform, based on a plurality of dictionaries, dictionary decompression on the plurality of groups of low-dimensional data on which the dictionary compression is performed, to obtain the plurality of groups of decompressed low-dimensional data. The communication apparatus may perform a dimension increase operation on the plurality of groups of low-dimensional data, to obtain a multidimensional data matrix.

In some implementations, the multidimensional data matrix may include CSI, and the plurality of groups of low-dimensional data may include at least one frequency description vector group and at least one spatial description vector group, where a quantity of frequency description vector groups in the at least one frequency description vector group is the same as a quantity of spatial description vector groups in the at least one spatial description vector group, and a quantity of frequency description vectors in the frequency description vector group is the same as a quantity of spatial description vectors in the spatial description vector group.

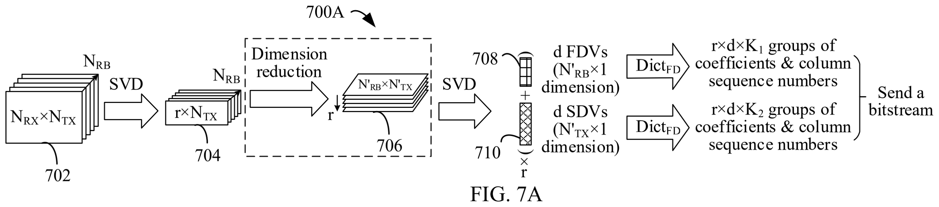

FIG. 7A is a diagram of an example implementation of a method 700A for compressing CSI according to some embodiments of this application. The method 700A is described with reference to FIG. 1. The method 700A may be performed by the terminal device 110 in FIG. 1.

As shown in FIG. 7A, the terminal device 110 obtains CSI associated with the network device 120. The CSI may be represented by a three-dimensional matrix 702 whose dimension is $N_{RX} \times N_{TX} \times N_{RB}$, where $N_{RX}$ represents a quantity of receive antennas of the terminal device 110, $N_{TX}$ represents a quantity of transmit antennas of the network device 120, and $N_{RB}$ represents a quantity of subcarriers needed for sending the CSI. The terminal device 110 separately performs SVD preprocessing on a data matrix that is of the three-dimensional matrix 702 and that corresponds to each resource block (resource block, RB), to perform a dimension reduction operation on the three-dimensional matrix 702, where each RB corresponds to one subcarrier or frequency domain signal, and a dimension of a data matrix corresponding to one RB is $N_{RX} \times N_{TX}$. For example, based on the SVD preprocessing for each RB, the terminal device 110 may convert the corresponding data matrix whose dimension is $N_{RX} \times N_{TX}$ into r right eigenvectors, namely, a matrix of $r \times N_{TX}$. Based on the SVD preprocessing for all RBs, the terminal device 110 may convert the three-dimensional matrix 702 whose dimension is $N_{RX} \times N_{TX} \times N_{RB}$ into a data matrix 704 whose dimension is $r \times N_{TX} \times N_{RB}$. It may be understood that the terminal device 110 may alternatively perform a dimension reduction operation on the three-dimensional matrix 702 through another operation.

The terminal device 110 may perform singular value decomposition (SVD) processing on a data matrix (whose dimension is $N_{TX} \times N_{RB}$) corresponding to each rank (rank) of the data matrix 704, to perform the dimension reduction operation on the three-dimensional matrix 704. For example, based on the SVD processing for each rank, the terminal device 110 may convert the corresponding data matrix whose dimension is $N_{TX} \times N_{RB}$ into d groups of eigenvectors of most principal components, where each group of eigenvectors of most principal components includes a frequency description vector (frequency description vector, FDV) 708 whose dimension is $N_{RB} \times 1$ and a spatial description vector (spatial description vector, SDV) 710 whose dimension is $N_{TX} \times 1$. Based on the SVD processing for all ranks, the terminal device 110 may convert the three-dimensional matrix 704 whose dimension is $r \times N_{TX} \times N_{RB}$ into $r \times d$ groups of eigenvectors, where each group of eigenvectors may include the FDV 708 and the SDV 710. It may be understood that the terminal device 110 may alternatively perform a dimension reduction operation on a three-dimensional matrix 706 through another operation.

In some embodiments, the terminal device 110 may perform a DFT codebook dimension reduction operation on the data matrix 704, to obtain a three-dimensional matrix 706 whose dimension is $r \times N'_{TX} \times N'_{RB}$, where $N'_{TX} \leq N_{TX}$, and $N'_{RB} \leq N_{RB}$. The terminal device 110 may perform an SVD operation on the three-dimensional matrix 706 to obtain a plurality of groups of eigenvectors FDVs 708 whose dimension is $N'_{RB} \times 1$ and eigenvectors SDVs 710 whose dimension is $N'_{TX} \times 1$.

The terminal device 110 and the network device 120 may share a dictionary $Dict_{FD}$ for FDVs and a dictionary $Dict_{SD}$ for SDVs. The terminal device 110 may separately compress $r \times d$ FDVs based on the dictionary $Dict_{FD}$, to obtain $r \times d \times K_1$ groups of column sequence numbers and corresponding weighting coefficients.

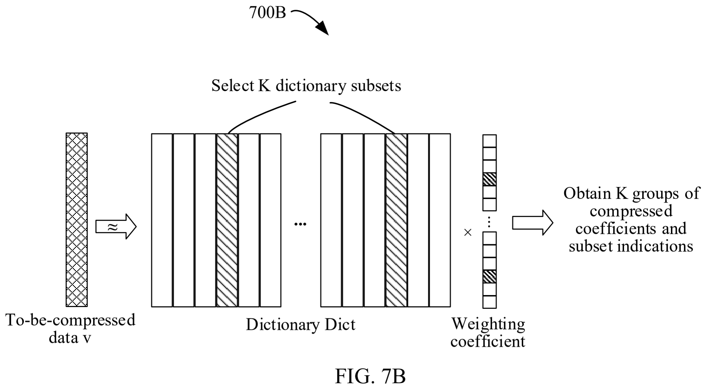

Weighted representation can be performed on each FDV by using a dictionary column corresponding to $K_1$ groups of column sequence numbers in the dictionary $Dict_{FD}$ and corresponding weighting coefficients. $K_1$ may be a preconfigured dictionary compression parameter for the dictionary $Dict_{FD}$. Similarly, the terminal device 110 may compress $r×d$ SDVs based on the dictionary $Dict_{SD}$, to obtain $r×d×K_2$ groups of column sequence numbers and corresponding weighting coefficients. Weighted representation can be performed on each SDV by using a dictionary column corresponding to $K_2$ groups of column sequence numbers in the dictionary $Dict_{SD}$ and corresponding weighting coefficients. $K_2$ may be a preconfigured dictionary compression parameter for the dictionary $Dict_{SD}$. In some embodiments, $K_1$ and $K_2$ may be the same. Alternatively, $K_1$ and $K_2$ may be different. A specific implementation of dictionary compression is described in detail below with reference to FIG. 7B.

Therefore, the terminal device 110 may represent the three-dimensional matrix 702 by using dictionary subset sequence numbers and coefficients. In the example of the method 700A, the dictionary subset sequence numbers and the coefficients may include the $r×d×K_1$ groups of column sequence numbers and the corresponding weighting coefficients that are obtained based on the dictionary $Dict_{FD}$, and the $r×d×K_2$ groups of column sequence numbers and the corresponding weighting coefficients that are obtained based on the dictionary $Dict_{SD}$. The terminal device 110 may represent the dictionary subset sequence numbers and the coefficients as a bit sequence set, and send the bit sequence set to the network device 120.

In some embodiments, the bit sequence set includes a total of $r × d × \sum_{i=1}^{2} Ki×(L_{coeff,i}+L_{idx,i})$ bits, where $L_{idx.i}$ and $L_{coeff.i}$ are respectively a quantity of bits needed for one dictionary subset sequence number (namely, a column sequence number) and a quantity of bits needed for one weighting coefficient corresponding to one dictionary subset, $L_{idx,1}$ and $L_{coeff,1}$ correspond to parameters of an FDV, and $L_{idx,2}$ and $L_{coeff,2}$ correspond to parameters of an SDV. In some embodiments, different quantities of quantization bits may be used for different coefficients.

The network device 120 may convert, based on the dictionary $Dict_{FD}$ and the dictionary $Dict_{SD}$, the bit sequence set received from the terminal device 110 into a plurality of groups of FDVs and SDVs, and convert the plurality of groups of FDVs and SDVs into a three-dimensional matrix whose dimension is $N_{RX}×N_{TX}×N_{RB}$ through a corresponding dimension increase operation, to obtain the CSI.

In this way, a plurality of groups of low-dimensional data may be obtained by performing processing such as transformation and dimension reduction on high-dimensional data, and each group of low-dimensional data is compressed by using a corresponding dictionary, so that transmission resources needed for data transmission can be reduced while high accuracy of data compression is ensured.

FIG. 7B is a diagram of an example implementation of a dictionary compression method 700B according to some embodiments of this application. The method 700B is described with reference to FIG. 1. The method 700B may be performed by the terminal device 110 in FIG. 1.

As shown in FIG. 7B, for to-be-compressed data v, the terminal device 110 may determine K dictionary subsets in a corresponding dictionary Dict, where an approximate value v' of the data v may be represented as

$$v' = \sum_{k=1}^{K} w_{ind_k} x_{ind_k}$$

, $x_{indk}$, represents a $k^{th}$ dictionary subset used for weighted representation of the data v, $w_{indk}$ represents a weighting coefficient corresponding to the $k^{th}$ dictionary subset $x_{indk}$ used for the weighted representation of the data v, and $ind_k$ may represent a sequence number of the dictionary subset $x_{indk}$ in the dictionary Dict. v' is determined to satisfy that a difference between v and v' is the smallest. For example, v' may be determined by minimizing an NMSE or maximizing a GCS.

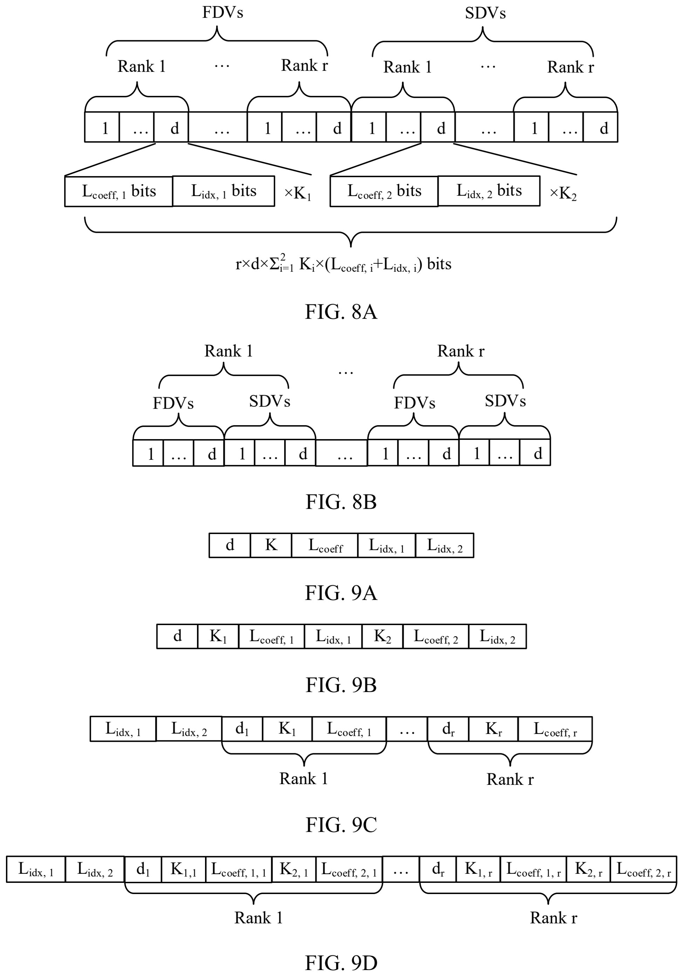

FIG. 8A is a diagram of an example implementation of a bit sequence set according to some embodiments of this application. The bit sequence set in FIG. 8A is described with reference to the method 700A shown in FIG. 7A. In the method 700A, the terminal device 110 converts the three-dimensional matrix 702 into $r×d$ groups of FDV bit sequences and $r×d$ groups of SDV bit sequences, where each group of FDV bit sequences may represent $K_1$ groups of column sequence numbers and corresponding weighting coefficients that represent a corresponding FDV, and correspondingly, each group of FDV bit sequences includes $K_1×(L_{coeff,1}+L_{idx,1})$ bits; and each group of SDV bit sequences may represent $K_2$ groups of column sequence numbers and corresponding weighting coefficients that represent a corresponding SDV, and correspondingly, each group of SDV bit sequences includes $K_2×(L_{coeff,2}+L_{idx,2})$ bits. The rank after the conversion is r, where for each rank, there are d groups of FDV bit sequences and d groups of SDV bit sequences in total.

As shown in FIG. 8A, bit sequences may be spliced in an order of frequency domain components (FDVs) first and then spatial components (SDVs). Inside each component, splicing may be performed in an order of ranks, d groups of bit sequences are obtained in each rank, and each group of bit sequences corresponds to information about one FDV or one SDV. Correspondingly, each group of bit sequences includes bit representations (which are $K_1×(L_{coeff,1}+L_{idx,1})$ bits or $K_2×(L_{coeff,2}+L_{idx,2})$ bits) of $K_1$ or $K_2$ groups of coefficients and sequence numbers.

For example, d groups of FDV bit sequences for each rank may be spliced together, and d groups of SDV bit sequences for each rank may be spliced together. According to an order of ranks (for example, Rank 1, Rank 2, ..., and Rank r), the d groups of FDV bit sequences for each rank are spliced together, to obtain $r \times d$ groups of FDV bit sequences, including $r \times d \times K_1 \times (L_{coeff,1} + L_{idx,1})$ bits in total. Similarly, according to the order of ranks (for example, Rank 1, Rank 2, ..., and Rank r), the d groups of SDV bit sequences for each rank may be spliced together, to obtain $r \times d$ groups of SDV bit sequences, including $r \times d \times K_2 \times (L_{coeff,2} + L_{idx,2})$ bits in total. The $r \times d$ groups of FDV bit sequences and the $r \times d$ groups of SDV bit sequences may be spliced together, to obtain a to-be-sent bit sequence set.

FIG. 8B is a diagram of an example implementation of another bit sequence set according to some embodiments of this application. The bit sequence set in FIG. 8B is described with reference to the method 700A shown in FIG. 7A. In the method 700A, the terminal device 110 converts the three-dimensional matrix 702 into $r \times d$ groups of FDV bit sequences and $r \times d$ groups of SDV bit sequences, where each group of FDV bit sequences may represent $K_1$ groups of column sequence numbers and corresponding weighting coefficients that represent a corresponding FDV, and correspondingly, each group of FDV bit sequences includes $K_1 \times (L_{coeff,1} + L_{idx,1})$ bits; and each group of SDV bit sequences may represent $K_2$ groups of column sequence numbers and corresponding weighting coefficients that represent a corresponding SDV, and correspondingly, each group of SDV bit sequences includes $K_2 \times (L_{coeff,2} + L_{idx,2})$ bits. The rank after the conversion is r, where for each rank, there are d groups of FDV bit sequences (a total of $d \times K_1 \times (L_{coeff,1} + L_{idx,1})$ bits) and d groups of SDV bit sequences (a total of $d \times K_2 \times (L_{coeff,2} + L_{idx,2})$ bits) in total.

As shown in FIG. 8B, frequency domain components (FDVs) corresponding to each rank are spliced first and then spatial components (SDVs) corresponding to each rank are spliced, and then splicing may be performed in an order of ranks. For example, d groups of FDV bit sequences for each rank may be spliced together, and d groups of SDV bit sequences for each rank may be spliced together. For each rank, the d groups of FDV bit sequences and the d groups of SDV bit sequences may be spliced together, to obtain a bit sequence for each rank, including $d \times K_1 \times (L_{coeff,1} + L_{idx,1}) + d \times K_2 \times (L_{coeff,2} + L_{idx,2})$ bits in total. According to an order of ranks (for example, Rank 1, Rank 2, ..., and Rank r), bit sequences for all the ranks may be spliced together, to obtain a to-be-sent bit sequence set.

It may be understood that the packet assembly manners of the bit sequence sets shown in FIG. 8A and FIG. 8B are merely examples, and are not intended to be limiting. Another proper packet assembly manner may be used. For example, in the bit sequence set shown in FIG. 8A or FIG. 8B, bits ($d \times K_1 \times L_{coeff,1}$ bits or $d \times K_2 \times L_{coeff,2}$ bits) of d consecutive groups of coefficients of an FDV or an SDV for each rank may be spliced together, bits ($d \times K_1 \times L_{idx,1}$ bits or $d \times K_2 \times L_{idx,2}$ bits) of d consecutive groups of sequence numbers of the FDV or the SDV for each rank may be spliced together, and splicing is further performed to form an FDV bit sequence (a total of $d \times K_1 \times (L_{coeff,1} + L_{idx,1})$ bits) for each rank and an SDV bit sequence (a total of $d \times K_2 \times (L_{coeff,2} + L_{idx,2})$ bits) for each rank. Alternatively, the bits of all the coefficients may be spliced together, and the bits of all the sequence numbers may be spliced together.

In some embodiments, a dimension reduction operation may be considered, and a parameter of the dimension reduction operation and an FDV/SDV bit sequence are spliced and then sent together. For example, a sequence number of a spatial domain DFT orthogonal basis and a sequence number of a frequency domain DFT orthogonal basis may be respectively represented in a form of a bitmap or a combinatorial number.

In some embodiments, a dictionary compression parameter may be dynamically adjusted under a given transmission resource limitation. Return to FIG. 7A. In the method 700A, the terminal device 110 converts the three-dimensional matrix 702 into the $r \times d$ groups of FDV bit sequences and the $r \times d$ groups of SDV bit sequences, where there are $r \times d \times K_1 \times (L_{coeff,1} + L_{idx,1}) + r \times d \times K_2 \times (L_{coeff,2} + L_{idx,2})$ bits in total. For example, assuming that a CSI feedback resource is allocated in advance, a maximum length $L_{max}$ of a compressed CSI bit sequence may be obtained through conversion. The dictionary compression parameter may be configured based on $L_{max}$.

For example, the rank r may be preconfigured (for example, via upper layer RRC signaling) or predetermined (for example, based on a channel state calculation parameter). d, $K_1$, $K_2$, $L_{coeff,1}$, $L_{coeff,2}$, $L_{idx,1}$, and $L_{idx,2}$ may be adjusted under the constraint of $r \times d \times K_1 \times (L_{coeff,1} + L_{idx,1}) + r \times d \times K_2 \times (L_{coeff,2} + L_{idx,2}) \leq L_{max}$.

In some embodiments, to ensure similar compression and quantization effects for an FDV and an SDV, $K_1 = K_2 = K$, and $L_{coeff,1} = L_{coeff,2} = L_{coeff}$, so that the foregoing constraint is simplified as $d \times K \times (2L_{coeff} + L_{idx,1} + L_{idx,2}) \leq L_{max}/r$.

In some embodiments, $L_{idx,1}$ and $L_{idx,2}$ may be respectively determined by quantities of columns of $Dict_{FD}$ and $Dict_{SD}$, that is,

$$L_{idx,1} = \lceil \log_2(\text{quantity of columns of } Dict_{FD}) \rceil,$$ and

$$L_{idx,2} = \lceil \log_2(\text{quantity of columns of } Dict_{SD}) \rceil.$$

In some embodiments, impact of d on a GCS indicator after CSI data compression and reconstruction may be evaluated based on previous training data, and a smallest d is selected, so that an average value of GCSs exceeds a preset threshold.

In some embodiments, under the constraint of $K \times (2L_{coeff} + L_{idx,1} + L_{idx,2}) \leq L_{max}/r/d$, a quantity K of coefficients may be given first, and then a quantization bit width $L_{coeff}$ of a dictionary compression coefficient is set.

Alternatively, different d may be set for different ranks, or different quantization bit widths $L_{coeff}$ may be set for different coefficients.

In some embodiments, the terminal device 110 may independently configure the foregoing dictionary compression parameters d, $K_1$, $K_2$, $L_{coeff,1}$, $L_{coeff,2}$, $L_{idx,1}$, and $L_{idx,2}$. In some embodiments, the terminal device 110 may send the configured parameters to the network device 120 over an uplink channel.

In some embodiments, the network device 120 may determine the foregoing dictionary compression parameters d, $K_1$, $K_2$, $L_{coeff,1}$, $L_{coeff,2}$, $L_{idx,1}$, and $L_{idx,2}$, and send corresponding configuration information to the terminal device 110. For example, the network device 120 may send the corresponding configuration information to the terminal device 110 via upper layer RRC signaling or MAC/PDCCH signaling, to complete configuration of the compression parameters.

FIG. 9A to FIG. 9D are diagrams of example implementations of information including a dictionary compression parameter according to some embodiments of this application. As shown in FIG. 9A, a same dictionary compression parameter may be used for each rank. Quantities of dictionary compression coefficients of an FDV and an SDV are the same, and quantization bit widths of the dictionary compression coefficients are the same.

As shown in FIG. 9B, a same dictionary compression parameter may be used for each rank. Quantities of dictionary compression coefficients of an FDV and an SDV, and quantization bit widths of the dictionary compression coefficients may be separately configured.

As shown in FIG. 9C, a dictionary compression parameter for each rank may be separately configured. For each rank, quantities of dictionary compression coefficients of an FDV and an SDV are the same, and quantization bit widths of the dictionary compression coefficients are the same. $L_{idx,1}$ and $L_{idx,2}$ may be determined by a quantity of dictionary columns, and is irrelevant to a rank.

As shown in FIG. 9D, a dictionary compression parameter for each rank may be separately configured. For each rank, quantities of dictionary compression coefficients of an FDV and an SDV may be separately configured, and quantization bit widths of the dictionary compression coefficients may be separately configured. $L_{idx,1}$ and $L_{idx,2}$ may be determined by a quantity of dictionary columns, and is irrelevant to a rank.

In some embodiments, at least some dictionary compression parameters may be preset or predetermined. Information that includes the dictionary compression parameters may include only the remaining parameters. For example, a quantization bit quantity (for example, $L_{coeff,1}$ or $L_{coeff,2}$) of a weighting coefficient obtained through dictionary compression may be preset, and is, for example, fixed to 8 bits. After a size of a dictionary is determined, a quantity of index bits (for example, $L_{idx,1}$ or $L_{idx,2}$) obtained through dictionary compression may be directly determined. In some embodiments, a rank (for example, r) may be obtained through current channel quality assessment. Alternatively, a rank (for example, r) may be redetermined. If the foregoing parameters are determined, only a quantity K of subsets used for dictionary compression and a quantity d of eigenvectors reserved for a dimension reduction operation need to be adjusted.

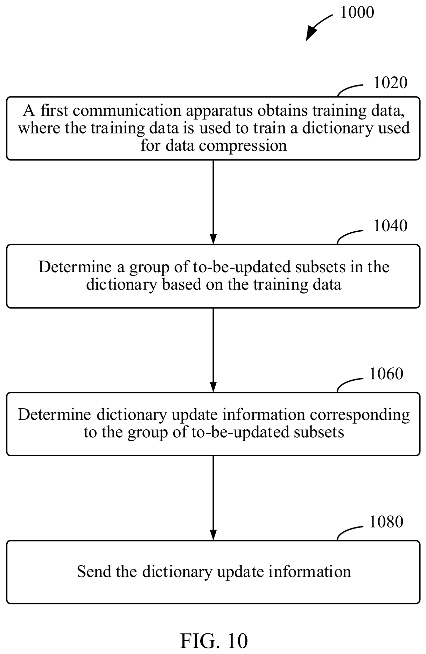

FIG. 10 is a schematic flowchart of a method 1000 implemented at a first communication apparatus according to some embodiments of this application. In a possible implementation, the method 1000 may be implemented by the first communication apparatus 210 in FIG. 2. The first communication apparatus 210 may be the terminal device 110 (or the chip of the terminal device 110) or the network device 120 (or the chip of the network device 120) in the example communication system 100 in FIG. 1. In another possible implementation, the method 1000 may alternatively be implemented by another electronic apparatus independent of the example communication system 100. As an example, the method 1000 is described below by using an example in which the first communication apparatus 210 in FIG. 2 performs the method.

In 1020, the first communication apparatus 210 obtains training data, where the training data is used to train a dictionary used for data compression.

In 1040, the first communication apparatus 210 determines a group of to-be-updated subsets in the dictionary based on the training data.

In 1060, the first communication apparatus 210 determines dictionary update information corresponding to the group of to-be-updated subsets.

In 1070, the first communication apparatus 210 sends the dictionary update information.

In some embodiments, the dictionary update information may include indication information of a subset in the group of to-be-updated subsets and an update value for the subset in the group of to-be-updated subsets. The update value may be one of the following: an updated value of the subset or a differential value between the updated value and an initial value of the subset.

In some embodiments, the dictionary update information may include the update value compressed based on compression control information. The compression control information may include at least one of the following: a quantization mode, a quantization bit quantity, a transform mode, or an entropy coding mode.

In some embodiments, the method may further include: determining the compression control information, and sending the compression control information.

In some embodiments, the method may further include: receiving the compression control information.

In some embodiments, obtaining the training data may include: receiving the training data from a second communication apparatus.

In some embodiments, obtaining the training data may include: periodically receiving the training data from a second communication apparatus.

In some embodiments, the method may further include: receiving a resource request from a second communication apparatus; and sending a resource allocation indication to the second communication apparatus.

In some embodiments, the dictionary may be generated based on a basic training data set, and the basic training data set may be selected from at least one predetermined basic training data set.

In some embodiments, sending the dictionary update information may include: sending the dictionary update information to a second communication apparatus and a third communication apparatus.

In some embodiments, the method may further include: performing a dimension reduction operation on a to-be-sent multidimensional data matrix, to obtain a plurality of groups of low-dimensional data, where the first communication apparatus stores a plurality of dictionaries including the dictionary, and the plurality of dictionaries respectively correspond to the plurality of groups of low-dimensional data; performing dictionary compression on the plurality of groups of low-dimensional data based on the plurality of dictionaries; and sending the plurality of groups of low-dimensional data on which the dictionary compression is performed.

In some embodiments, the method may further include: receiving a plurality of groups of low-dimensional data on which dictionary compression is performed; performing, based on a plurality of dictionaries including the dictionary, dictionary decompression on the plurality of groups of low-dimensional data on which the dictionary compression is performed; and performing a dimension increase operation on the plurality of groups of low-dimensional data on which the dictionary decompression is performed, to obtain a multidimensional data matrix.

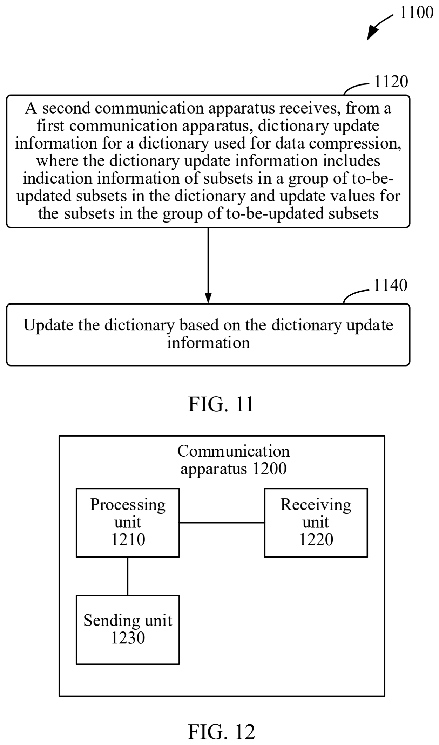

FIG. 11 is a schematic flowchart of a method 1100 implemented at a second communication apparatus according to some embodiments of this application. In a possible implementation, the method 1100 may be implemented by the second communication apparatus 220 in FIG. 2. The second communication apparatus 220 may be the network device 120 (or the chip of the network device 120) or the terminal device 110 (or the chip of the terminal device 110) in the example communication system 100 in FIG. 1. In another possible implementation, the method 1100 may alternatively be implemented by another electronic apparatus independent of the example communication system 100. As an example, the method 1100 is described below by using an example in which the second communication apparatus 220 in FIG. 2 performs the method.

In 1120, the second communication apparatus 220 receives, from the first communication apparatus 210, dictionary update information for a dictionary used for data compression. The dictionary update information includes indication information of a subset in a group of to-be-updated subsets in the dictionary and an update value for the subset in the group of to-be-updated subsets.

In 1140, the second communication apparatus 220 updates the dictionary based on the dictionary update information.

In some embodiments, the dictionary update information may include indication information of a subset in the group of to-be-updated subsets and an update value for the subset in the group of to-be-updated subsets. The update value may be one of the following: an updated value of the subset or a differential value between the updated value and an initial value of the subset.

In some embodiments, the dictionary update information may include the update value compressed based on compression control information. The compression control information may include at least one of the following: a quantization mode, a quantization bit quantity, a transform mode, or an entropy coding mode.

In some embodiments, the method may further include: determining the compression control information, and sending the compression control information.

In some embodiments, the method may further include: receiving the compression control information.

In some embodiments, the method may further include: sending training data compressed based on compression control information to the first communication apparatus, where the compression control information includes at least one of the following: a quantization mode, a quantization bit quantity, a transform mode, or an entropy coding mode.

In some embodiments, sending the compressed training data to the first communication apparatus may include: periodically sending the compressed training data to the first communication apparatus.

In some embodiments, sending the compressed training data to the first communication apparatus may include: sending a resource request to the first communication apparatus; receiving a resource allocation indication from the first communication apparatus; and sending the compressed training data to the first communication apparatus based on the resource allocation indication.

In some embodiments, the resource request may be sent to the first communication apparatus based on at least one of the following: an amount of the training data reaches a predetermined amount threshold; or a percentage of the training data in data to be sent to the first communication apparatus reaches a predetermined percentage threshold.

In some embodiments, the dictionary may be generated based on a basic training data set, and the basic training data set may be selected from at least one predetermined basic training data set.

In some embodiments, the method may further include: sending the training data to a third communication apparatus.

In some embodiments, the training data is first training data, and the method further includes: receiving second training data from the third communication apparatus, where the first training data is determined based on the second training data.

In some embodiments, the method may further include: performing a dimension reduction operation on a to-be-sent multidimensional data matrix, to obtain a plurality of groups of low-dimensional data, where the first communication apparatus stores a plurality of dictionaries including the dictionary, and the plurality of dictionaries respectively correspond to the plurality of groups of low-dimensional data; performing dictionary compression on the plurality of groups of low-dimensional data based on the plurality of dictionaries; and sending the plurality of groups of low-dimensional data on which the dictionary compression is performed.

In some embodiments, the method may further include: receiving a plurality of groups of low-dimensional data on which dictionary compression is performed; performing, based on a plurality of dictionaries including the dictionary, dictionary decompression on the plurality of groups of low-dimensional data on which the dictionary compression is performed; and performing a dimension increase operation on the plurality of groups of low-dimensional data on which the dictionary decompression is performed, to obtain a multidimensional data matrix.

According to embodiments of this application, efficient dynamic dictionary update can be supported. For example, a dictionary related to CSI can adapt to a time-varying channel. In some embodiments of this application, an efficient data compression method based on a dynamic dictionary can be provided, thereby improving overall compression efficiency and saving bandwidth resources. In some embodiments, flexible and controllable fixed-length compression can be implemented, to facilitate flexible matching of transmission resources.

FIG. 12 is a diagram of a structure of a possible communication apparatus (also referred to as a communication device) according to an embodiment of the present disclosure. The communication apparatus can implement functions of a terminal apparatus or a network apparatus in the foregoing method embodiments. Therefore, beneficial effects of the foregoing method embodiments can also be implemented. In this embodiment of the present disclosure, the communication apparatus may be the first communication apparatus 210 or the second communication apparatus 220 in FIG. 2, or the terminal device 110 or the network device 120 in FIG. 1, or a module (for example, a chip) of the communication apparatus or the terminal device.

As shown in FIG. 12, the communication apparatus 1200 includes a processing unit 1210, a receiving unit 1220, and a sending unit 1230. The communication apparatus may be configured to implement a function of dynamically updating a dictionary or compressing data based on a dictionary in the method embodiments shown in any one of FIG. 1 to FIG. 11. In some embodiments, the processing unit may be a processor, the sending unit may be a transmitter, and the receiving unit may be a receiver.

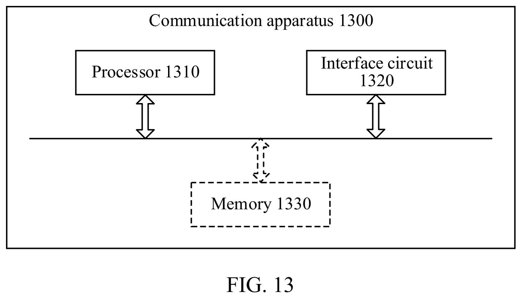

FIG. 13 is a simplified block diagram of a possible communication apparatus (also referred to as a communication device) according to an embodiment of the present disclosure. As shown in FIG. 13, a communication apparatus 1300 includes a processor 1310 and an interface circuit 1320. The processor 1310 and the interface circuit 1320 are coupled to each other. It may be understood that the interface circuit 1320 may be a transceiver or an input/output interface. Optionally, the communication apparatus 1300 may further include a memory 1330, configured to store instructions executed by the processor 1310, store input data needed by the processor 1310 to run instructions, or store data generated after the processor 1310 runs instructions.

When the communication apparatus 1300 is configured to implement the methods in the foregoing method embodiments, the processor 1310 is configured to perform a function of the processing unit 1210, and the interface circuit 1320 is configured to perform functions of the receiving unit 1220 and the sending unit 1230.

It may be understood that the processor in embodiments of the present disclosure may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor.

An embodiment of the present disclosure provides a communication system. The communication system may include the communication apparatus in the embodiment shown in FIG. 12, for example, the first communication apparatus 210 or the second communication apparatus 220 in FIG. 2, or the terminal device 110 or the network device 120 in FIG. 1, or a module (for example, a chip) of the communication apparatus or the terminal device. Optionally, the first communication apparatus 210, the second communication apparatus 220, the terminal device 110, the network device 120, or the module (for example, the chip) of the communication apparatus or the terminal device in the communication system can perform the communication method shown in any one of FIG. 1 to FIG. 11.

An embodiment of the present disclosure further provides a circuit. The circuit may be coupled to a memory, and may be configured to perform a procedure related to the first communication apparatus 210, the second communication apparatus 220, the terminal device 110, the network device 120, or the module (for example, the chip) of the communication apparatus or the terminal device in any one of the foregoing method embodiments. The chip system may include the chip, and may further include another component, for example, a memory or a transceiver.

It should be understood that the processor mentioned in embodiments of the present disclosure may be a CPU, or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It should be further understood that the memory mentioned in embodiments of the present disclosure may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example, and not limitation, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus dynamic random access memory (direct rambus RAM, DR RAM).

It should be noted that when the processor is a general-purpose processor, a DSP, an ASIC, an FPGA or another programmable logic device, a discrete gate or a transistor logic device, or a discrete hardware component, the memory (storage module) is integrated into the processor.

It should be noted that the memory described in this specification aims to include but is not limited to these memories and any memory of another proper type.

It should be understood that sequence numbers of the foregoing processes do not mean execution sequences in various embodiments of the present disclosure. The execution sequences of the processes should be determined according to functions and internal logic of the processes, and should not be construed as any limitation on the implementation processes of embodiments of the present disclosure.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of the present disclosure.

It may be clearly understood by a person skilled in the art that, for the purpose of convenient and brief description, for a detailed working process of the foregoing system, apparatus, and module, refer to a corresponding process in the foregoing method embodiments. Details are not described herein again.

In the several embodiments provided in the present disclosure, it should be understood that the disclosed communication methods and apparatuses may be implemented in other manners. For example, the described apparatus embodiments are merely examples. For example, division of modules is merely division of logical functions and there may be other division modes during actual application. For example, a plurality of modules or components may be combined or may be integrated to another system, or some characteristics may be ignored or not executed. In addition, the displayed or discussed mutual couplings or direct couplings or communication connections may be implemented through some interfaces. The indirect couplings or communication connections between the apparatuses or units may be implemented in electronic, mechanical, or other forms.

The modules described as separate parts may or may not be physically separate, and parts displayed as modules may or may not be physical modules, to be specific, may be located at one position, or may be distributed on a plurality of network units. Some or all of the units may be selected based on actual requirements to achieve the objectives of the solutions of embodiments.

In addition, functional modules in embodiments of the present disclosure may be integrated into one processing module, or each of the modules may exist alone physically, or two or more modules may be integrated into one module.

When functions are implemented in a form of a software functional module and sold or used as an independent product, the functions may be stored in a computer-readable storage medium. Based on such an understanding, the technical solutions of the present disclosure essentially, or the contributing part, or some of the technical solutions may be implemented in a form of a software product. The computer software product is stored in a storage medium, and includes several instructions for indicating a computer device (which may be a personal computer, a server, or a network device) to perform all or a part of the steps of the methods described in embodiments of the present disclosure. The foregoing computer-readable storage medium may be any usable medium that can be accessed by a computer. The following provides an example but does not impose a limitation: The computer-readable medium may include a random access memory (random access memory, RAM), a read-only memory (read-only memory, ROM), an electrically erasable programmable read-only memory (electrically erasable programmable read-only memory, EEPROM), a compact disc read-only memory (compact disc read-only memory, CD-ROM), a universal serial bus flash disk (universal serial bus flash disk), a removable hard disk, or another optical disc storage or a disk storage medium, or another magnetic storage device, or any other medium that can carry or store expected program code in a form of an instruction or a data structure and can be accessed by a computer.

As used in this specification, the term "include" and similar terms should be understood as open inclusion, that is, "include but not limited to". The term "based on" should be understood as "at least partially based on". The term "one embodiment" or "this embodiment" should be understood as "at least one embodiment". Terms such as "first", "second", and the like may refer to different objects or a same object, and are merely used to distinguish between specified objects, but do not imply a specific spatial order, a time order, an importance order, or the like of the specified objects. In some embodiments, a value, a process, a selected item, a determined item, a device, an apparatus, a means, a part, a component, or the like is referred to as "optimal", "lowest", "highest", "minimum", "maximum", or the like. It should be understood that such a description is intended to indicate that a selection may be made among many available functional selections, and that such a selection does not need to be better, lower, higher, smaller, larger, or otherwise preferred than other selections in other aspects or in all aspects. As used in this specification, the term "determining" may cover a variety of actions. For example, "determining" may include operating, calculation, processing, export, investigation, lookup (for example, lookup in a table, database, or another data structure), finding, and the like. In addition, "determining" may include receiving (for example, receiving information), accessing (for example, accessing data in a memory), and the like. In addition, "determining" may include parsing, selection, choice, establishment, and the like.

Embodiments may be further described using the following examples:

1. A method, including: obtaining, by a first communication apparatus, training data, where the training data is used to train a dictionary used for data compression; determining a group of to-be-updated subsets in the dictionary based on the training data; determining dictionary update information corresponding to the group of to-be-updated subsets; and sending the dictionary update information. In this way, efficient dictionary update can be supported, thereby reducing computing resources and wireless transmission resources consumed by dictionary update. Therefore, accuracy of dictionary compression can be improved.

2. The method according to example 1, where the group of to-be-updated subsets is determined based on an update value of a subset of a group of to-be-trained subsets in the dictionary, the group of to-be-trained subsets is determined based on the training data and the dictionary, and the update value of the subset is determined based on the training data and the group of to-be-trained subsets. Therefore, computing resources consumed by dictionary update training can be reduced.

3. The method according to example 1 or 2, where the dictionary update information includes: indication information of a subset in the group of to-be-updated subsets and an update value corresponding to the subset in the group of to-be-updated subsets, where the update value is one of the following: an updated value of the subset or a differential value between the updated value and an initial value of the subset. Therefore, wireless transmission resources needed for sending the dictionary update information can be reduced.

4. The method according to example 3, where the dictionary update information includes the update value compressed based on compression control information, and the compression control information includes at least one of the following: a quantization mode, a quantization bit quantity, a transform mode, or an entropy coding mode. Therefore, resources consumed for transmission of the dictionary update information can be reduced.

5. The method according to example 4, further including: determining the compression control information, and sending the compression control information. In this way, compression efficiency and accuracy of dictionary compression information can be improved, thereby facilitating dictionary sharing.

6. The method according to example 4, further including: receiving the compression control information. Therefore, compression efficiency and accuracy of dictionary compression information can be improved, thereby facilitating dictionary sharing.

7. The method according to any one of examples 3 to 6, further including: updating the dictionary based on the group of to-be-updated subsets and differential values corresponding to subsets in the group of to-be-updated subsets. Therefore, efficient dynamic dictionary update can be implemented, thereby improving accuracy of dictionary compression.

8. The method according to any one of examples 1 to 7, where obtaining the training data includes: performing dictionary compression on to-be-sent data based on the dictionary to obtain dictionary compressed data; decompressing the dictionary compressed data based on the dictionary to obtain reconstructed data; determining a loss function of the reconstructed data based on the to-be-sent data; and determining the training data based on the loss function of the reconstructed data. Therefore, computing resources consumed by dictionary update training can be reduced.

9. The method according to example 8, where determining the training data includes: determining, based on determining that the loss function of the reconstructed data reaches a loss function threshold, the to-be-sent data as being included in the training data. Therefore, computing resources consumed by dictionary update training can be reduced while accuracy of dictionary compression is improved.

10. The method according to example 8, where determining the training data includes:

sorting a plurality of pieces of to-be-sent data based on loss functions of reconstructed data corresponding to data in the plurality of pieces of to-be-sent data; and selecting the training data from the plurality of pieces of to-be-sent data based on the sorting. Therefore, computing resources consumed by dictionary update training can be reduced while accuracy of dictionary compression is improved.

11. The method according to any one of examples 1 to 7, where obtaining the training data includes: receiving, from a second communication apparatus, compressed data corresponding to the training data; and decompressing the compressed data based on compression control information to obtain the training data, where the compression control information includes at least one of the following: a quantization mode, a quantization bit quantity, a transform mode, or an entropy coding mode. Therefore, transmission bandwidth consumption of the training data can be reduced by compressing the training data.

12. The method according to any one of examples 1 to 7 and 11, where obtaining the training data includes: periodically receiving the training data from the second communication apparatus. Therefore, accuracy of dictionary compression can be improved.

13. The method according to any one of examples 1 to 7 and 11, further including: receiving a resource request from the second communication apparatus; and sending a resource allocation indication to the second communication apparatus. Therefore, accuracy of dictionary compression can be improved while computing resources consumed by dictionary update training are reduced.

14. The method according to any one of examples 1 to 7 and 11 to 13, where sending the dictionary update information includes: sending the dictionary update information to the second communication apparatus and a third communication apparatus. Therefore, the dictionary can be shared between a group of communication apparatuses, thereby reducing computing resources consumed by the dynamic dictionary.

15. The method according to example 14, where the training data includes at least one of the following:

first training data received from the second communication apparatus, or second training data received from the third communication apparatus. Therefore, the dynamic dictionary can be adapted to a group of communication apparatuses.

16. The method according to any one of examples 1 to 15, further including: receiving a bit sequence set; determining, based on the bit sequence set, a plurality of groups of dictionary subsets and a plurality of groups of weighting coefficients corresponding to a plurality of dictionaries including the dictionary; determining a plurality of groups of low-dimensional data based on the plurality of dictionaries, where weighted representation can be performed on low-dimensional data in the plurality of groups of low-dimensional data based on a group of dictionary subsets in the plurality of groups of dictionary subsets and a group of weighting coefficients in the plurality of groups of weighting coefficients; and performing a dimension increase operation on the plurality of groups of low-dimensional data, to obtain a multidimensional data matrix. Therefore, the dynamic dictionary can be adapted to a group of communication apparatuses.

17. The method according to any one of examples 1 to 16, further including: performing a dimension reduction operation on the to-be-sent multidimensional data matrix to obtain the plurality of groups of low-dimensional data, where the first communication apparatus stores the plurality of dictionaries including the dictionary, and the plurality of dictionaries respectively correspond to the plurality of groups of low-dimensional data; performing dictionary compression on the plurality of groups of low-dimensional data based on the plurality of dictionaries, to determine at least one dictionary subset in the dictionary and a corresponding weighting coefficient for low-dimensional data in one group of low-dimensional data in the plurality of groups of low-dimensional data, where weighted representation can be performed on the low-dimensional data based on the at least one dictionary subset and the weighting coefficient; determining, based on the at least one dictionary subset and the weighting coefficient that correspond to the low-dimensional data, the bit sequence set corresponding to the plurality of groups of low-dimensional data; and sending the bit sequence set. Therefore, dictionary decompression of high-dimensional data can be implemented, so that transmission resources needed for data transmission are reduced while data compression performance is improved.

18. The method according to example 17, where the dimension reduction operation includes at least one of the following: a singular value decomposition operation, a tensor decomposition operation, a low-rank decomposition operation, and a discrete Fourier transform codebook dimension reduction operation. Therefore, transmission resources needed for data transmission can be reduced.

19. The method according to example 17 or 18, where the multidimensional data matrix includes channel state information, the plurality of groups of low-dimensional data include at least one frequency description vector group and at least one spatial description vector group, a quantity of frequency description vector groups in the at least one frequency description vector group is the same as a quantity of spatial description vector groups in the at least one spatial description vector group, and a quantity of frequency description vectors in the frequency description vector group is the same as a quantity of spatial description vectors in the spatial description vector group. Therefore, dictionary compression of the channel state information can be implemented.

20. The method according to example 19, where determining the bit sequence set includes: determining, for the frequency description vector group in the at least one frequency description vector group, at least one frequency domain bit sequence corresponding to the at least one frequency description vector group by splicing a frequency domain indication information bit sequence of indication information of the at least one subset corresponding to the frequency description vectors in the frequency description vector group and a frequency domain coefficient bit sequence of the corresponding weighting coefficient; and determining, for the spatial description vector group in the at least one spatial description vector group, at least one spatial domain bit sequence corresponding to the at least one spatial description vector group by splicing a spatial domain indication information bit sequence of indication information of the at least one subset corresponding to the spatial description vectors in the spatial description vector group and a spatial domain coefficient bit sequence of the corresponding weighting coefficient. Therefore, dictionary compression of the channel state information can be implemented.

21. The method according to example 20, where determining the bit sequence set further includes: determining a total frequency domain bit sequence by splicing the at least one frequency domain bit sequence corresponding to the at least one frequency description vector group; determining a total spatial domain bit sequence by splicing the at least one spatial domain bit sequence corresponding to the at least one spatial description vector group; and determining the bit sequence set by splicing the total frequency domain bit sequence and the total spatial domain bit sequence. Therefore, transmission resources needed for data transmission can be reduced, and accuracy of dictionary compression and decompression can be improved.

22. The method according to example 20, where determining the bit sequence set further includes: determining at least one frequency-spatial domain bit sequence by splicing a frequency domain bit sequence in the at least one frequency domain bit sequence and a corresponding spatial domain bit sequence in the at least one spatial domain bit sequence; and determining the bit sequence set by splicing the at least one frequency-spatial domain bit sequence. Therefore, transmission resources needed for data transmission can be reduced, and accuracy of dictionary compression and decompression can be improved.

23. The method according to any one of examples 17 to 22, further including: determining a compression parameter used for the dictionary compression based on a predetermined bit sequence set transmission resource. Therefore, it can be convenient to reserve a transmission resource for data on which the dictionary compression is performed, thereby reducing signaling overheads and improving data transmission efficiency.

24. The method according to any one of examples 20 to 22, further including: determining a maximum length of the bit sequence set based on a predetermined bit sequence set transmission resource; determining the quantity of frequency description vector groups in the at least one frequency description vector group; and determining, based on the maximum length of the bit sequence set and the quantity of frequency description vector groups in the at least one frequency description vector group, a compression parameter used for the dictionary compression. Therefore, flexibility of a dictionary compression operation can be improved, so that a transmission resource can be flexibly matched.

25. The method according to any one of examples 20 to 22, further including: receiving a compression parameter used for the dictionary compression. Therefore, flexibility of a dictionary compression operation can be improved, so that a transmission resource can be flexibly matched.

26. The method according to example 24 or 25, where the compression parameter includes at least one of the following: the quantity of frequency description vectors in the frequency description vector group, a quantity of subsets of the at least one subset corresponding to the frequency description vectors, a quantity of subsets of the at least one subset corresponding to the spatial description vectors, a length of the frequency domain indication information bit sequence, a length of the frequency domain coefficient bit sequence, a length of the spatial domain indication information bit sequence, or a length of the spatial domain coefficient bit sequence. Therefore, flexibility of a dictionary compression operation can be improved, so that a transmission resource can be flexibly matched.

27. The method according to any one of examples 1 to 26, where the dictionary is generated based on a basic training data set, and the basic training data set is selected from at least one predetermined basic training data set. In this way, the communication apparatus sharing the dictionary can directly generate a dictionary for a predetermined scenario without obtaining a large amount of training data each time before generating the dictionary.

28. A method, including: receiving, by a second communication apparatus from a first communication apparatus, dictionary update information for a dictionary used for data compression, where the dictionary update information includes indication information of a subset in a group of to-be-updated subsets in the dictionary and an update value corresponding to the subset in the group of to-be-updated subsets; and updating the dictionary based on the dictionary update information.

29. The method according to example 28, where the update value is one of the following: an updated value of the subset or a differential value between the updated value and an initial value of the subset.

30. The method according to example 28 or 29, where the dictionary update information includes the update value compressed based on compression control information, and the compression control information includes at least one of the following: a quantization mode, a quantization bit quantity, a transform mode, or an entropy coding mode.

31. The method according to example 30, further including: receiving the compression control information.

32. The method according to example 30, further including: determining the compression control information, and sending the compression control information.

33. The method according to any one of examples 28 to 32, further including: determining training data; compressing the compressed data based on compression control information, where the compression control information includes at least one of a quantization mode, a quantization bit quantity, a transform mode, or an entropy coding mode; and sending the compressed training data to the first communication apparatus.

34. The method according to example 33, where determining the training data includes: performing, based on the dictionary, dictionary compression on data to be sent to the first communication apparatus, to obtain dictionary compressed data; decompressing the dictionary compressed data based on the dictionary to obtain reconstructed data; and determining a loss function of the reconstructed data based on the to-be-sent data; and determining the training data based on the loss function of the reconstructed data.

35. The method according to example 34, where determining the training data based on the loss function includes: determining, based on determining that the loss function of the reconstructed data reaches a loss function threshold, the to-be-sent data as being included in the training data.

36. The method according to example 34, where determining the training data based on the loss function includes: sorting, by the first communication apparatus, a plurality of pieces of to-be-sent data based on loss functions of reconstructed data corresponding to data in the plurality of pieces of data to be sent to the first communication apparatus; and selecting the training data from the plurality of pieces of to-be-sent data based on the sorting.

37. The method according to any one of examples 33 to 36, where sending the compressed training data to the first communication apparatus includes: periodically sending the compressed training data to the first communication apparatus.

38. The method according to any one of examples 33 to 36, where sending the compressed training data to the first communication apparatus includes: sending a resource request to the first communication apparatus; receiving a resource allocation indication from the first communication apparatus; and sending the compressed training data to the first communication apparatus based on the resource allocation indication.

39. The method according to example 38, where the resource request is sent to the first communication apparatus based on at least one of the following: an amount of the training data reaches a predetermined amount threshold; or a percentage of the training data in data to be sent to the first communication apparatus reaches a predetermined percentage threshold.

40. The method according to any one of examples 33 to 39, further including: sending the training data to a third communication apparatus. Therefore, the second communication apparatus and the third communication apparatus can adjust the training data to be sent to the first communication apparatus, thereby saving transmission resources and computing resources.

41. The method according to any one of examples 33 to 40, where the training data is first training data, and the method further includes: receiving second training data from the third communication apparatus, where the first training data is determined based on the second training data. Therefore, the second communication apparatus and the third communication apparatus can adjust the training data to be sent to the first communication apparatus, thereby saving transmission resources and computing resources.

42. The method according to any one of examples 28 to 41, further including: receiving a bit sequence set; determining, based on the bit sequence set, a plurality of groups of dictionary subsets and a plurality of groups of weighting coefficients corresponding to a plurality of dictionaries including the dictionary; determining a plurality of groups of low-dimensional data based on the plurality of dictionaries, where weighted representation can be performed on low-dimensional data in the plurality of groups of low-dimensional data based on a group of dictionary subsets in the plurality of groups of dictionary subsets and a group of weighting coefficients in the plurality of groups of weighting coefficients; and performing a dimension increase operation on the plurality of groups of low-dimensional data, to obtain a multidimensional data matrix.

43. The method according to any one of examples 28 to 42, further including: performing a dimension reduction operation on the multidimensional data matrix to be sent to the first communication apparatus, to obtain the plurality of groups of low-dimensional data, where the second communication apparatus stores the plurality of dictionaries including the dictionary, and the plurality of dictionaries respectively correspond to the plurality of groups of low-dimensional data; performing dictionary compression on the plurality of groups of low-dimensional data based on the plurality of dictionaries, to determine at least one dictionary subset in the dictionary and a corresponding weighting coefficient for low-dimensional data in one group of low-dimensional data in the plurality of groups of low-dimensional data, where weighted representation can be performed on the low-dimensional data based on the at least one dictionary subset and the weighting coefficient; determining, based on the at least one dictionary subset and the weighting coefficient that correspond to the low-dimensional data, the bit sequence set corresponding to the plurality of groups of low-dimensional data; and sending the bit sequence set to the first communication apparatus.

44. The method according to example 43, where the dimension reduction operation includes at least one of the following: a singular value decomposition operation, a tensor decomposition operation, a low-rank decomposition operation, and a discrete Fourier transform codebook dimension reduction operation.

45. The method according to example 43 or 44, where the multidimensional data matrix includes channel state information associated with the first communication apparatus, the plurality of groups of low-dimensional data include at least one frequency description vector group and at least one spatial description vector group, a quantity of frequency description vector groups in the at least one frequency description vector group is the same as a quantity of spatial description vector groups in the at least one spatial description vector group, and a quantity of frequency description vectors in the frequency description vector group is the same as a quantity of spatial description vectors in the spatial description vector group.

46. The method according to example 45, where determining the bit sequence set includes: determining, for the frequency description vector group in the at least one frequency description vector group, at least one frequency domain bit sequence corresponding to the at least one frequency description vector group by splicing a frequency domain indication information bit sequence of indication information of the at least one subset corresponding to the frequency description vectors in the frequency description vector group and a frequency domain coefficient bit sequence of the corresponding weighting coefficient; and determining, for the spatial description vector group in the at least one spatial description vector group, at least one spatial domain bit sequence corresponding to the at least one spatial description vector group by splicing a spatial domain indication information bit sequence of indication information of the at least one subset corresponding to the spatial description vectors in the spatial description vector group and a spatial domain coefficient bit sequence of the corresponding weighting coefficient.

47. The method according to example 46, where determining the bit sequence set further includes: determining a total frequency domain bit sequence by splicing the at least one frequency domain bit sequence corresponding to the at least one frequency description vector group; determining a total spatial domain bit sequence by splicing the at least one spatial domain bit sequence corresponding to the at least one spatial description vector group; and determining the bit sequence set by splicing the total frequency domain bit sequence and the total spatial domain bit sequence.

48. The method according to example 46, where determining the bit sequence set further includes: determining at least one frequency-spatial domain bit sequence by splicing a frequency domain bit sequence in the at least one frequency domain bit sequence and a corresponding spatial domain bit sequence in the at least one spatial domain bit sequence; and determining the bit sequence set by splicing the at least one frequency-spatial domain bit sequence.

49. The method according to any one of examples 43 to 48, further including: determining a compression parameter used for the dictionary compression based on a predetermined bit sequence set transmission resource.

50. The method according to any one of examples 46 to 48, further including: determining a maximum length of the bit sequence set based on a predetermined bit sequence set transmission resource; determining the quantity of frequency description vector groups in the at least one frequency description vector group; and determining, based on the maximum length of the bit sequence set and the quantity of frequency description vector groups in the at least one frequency description vector group, a compression parameter used for the dictionary compression.

51. The method according to any one of examples 46 to 48, further including: receiving a compression parameter used for the dictionary compression from the first communication apparatus.

52. The method according to example 50 or 51, where the compression parameter includes at least one of the following: the quantity of frequency description vectors in the frequency description vector group, a quantity of subsets of the at least one subset corresponding to the frequency description vectors, a quantity of subsets of the at least one subset corresponding to the spatial description vectors, a length of the frequency domain indication information bit sequence, a length of the frequency domain coefficient bit sequence, a length of the spatial domain indication information bit sequence, or a length of the spatial domain coefficient bit sequence.

53. The method according to any one of examples 28 to 52, where the dictionary is generated based on a basic training data set, and the basic training data set is selected from at least one predetermined basic training data set.

54. A first communication apparatus, including modules or units configured to perform the method according to any one of examples 1 to 27.

55. A second communication apparatus, including modules or units configured to perform the method according to any one of examples 28 to 53.

56. A first communication apparatus, including a processor, where the processor is coupled to a memory, the memory stores instructions, and when the instructions are executed by the processor, the first communication apparatus is caused to perform the method according to any one of examples 1 to 27.

57. A second communication apparatus, including a processor, where the processor is coupled to a memory, the memory stores instructions, and when the instructions are executed by the processor, the second communication apparatus is caused to perform the method according to any one of examples 28 to 53.

58. A computer-readable storage medium, where the computer-readable storage medium stores instructions, and when the instructions are run, the method according to any one of examples 1 to 53 is performed.

59. A computer program product, where the computer program product includes instructions, and when the instructions are run, the method according to any one of examples 1 to 53 is performed.

60. A communication system, including the first communication apparatus according to example 54 or 56 and the second communication apparatus according to example 55 or 57.

The foregoing descriptions are merely specific implementations of the present disclosure, but are not intended to limit the protection scope of the embodiments of the present disclosure. Any variation or replacement readily figured out by a person skilled in the art within the technical scope disclosed in embodiments of the present disclosure shall fall within the protection scope of embodiments of the present disclosure. Therefore, the protection scope of embodiments of the present disclosure should be subject to the protection scope of the claims.

## Claims

1. A method, comprising:

   obtaining, by a first communication apparatus, training data, wherein the training data is used to train a dictionary used for data compression;
   determining a group of to-be-updated subsets in the dictionary based on the training data;
   determining dictionary update information corresponding to the group of to-be-updated subsets; and
   sending the dictionary update information.

2. A method, comprising:

   receiving, by a second communication apparatus from a first communication apparatus, dictionary update information for a dictionary used for data compression, wherein the dictionary update information comprises indication information of a subset in a group of to-be-updated subsets in the dictionary and an update value for the subset in the group of to-be-updated subsets; and
   updating the dictionary based on the dictionary update information.

3. The method according to claim 1 or 2, wherein the dictionary update information comprises:

   indication information of a subset in the group of to-be-updated subsets; and
   an update value for the subset in the group of to-be-updated subsets, wherein the update value is one of the following: an updated value of the subset or a differential value between the updated value and an initial value of the subset.

4. The method according to claim 3, wherein the dictionary update information comprises the update value compressed based on compression control information, and the compression control information comprises at least one of the following: a quantization mode, a quantization bit quantity, a transform mode, or an entropy coding mode.

**5.** The method according to claim 4, further comprising:

determining the compression control information; and
sending the compression control information.

**6.** The method according to claim 4, further comprising:
receiving the compression control information.

**7.** The method according to any one of claims 1 or 3 to 6, wherein obtaining the training data comprises:
receiving the training data from a second communication apparatus.

**8.** The method according to any one of claims 1 or 3 to 7, wherein obtaining the training data comprises:
periodically receiving the training data from a second communication apparatus.

**9.** The method according to any one of claims 1 or 3 to 7, further comprising:

receiving a resource request from a second communication apparatus; and
sending a resource allocation indication to the second communication apparatus.

**10.** The method according to any one of claims 1 or 3 to 9, wherein sending the dictionary update information comprises:
sending the dictionary update information to a second communication apparatus and a third communication apparatus.

**11.** The method according to any one of claims 2 to 6, further comprising:
sending training data compressed based on compression control information to the first communication apparatus, wherein the compression control information comprises at least one of the following:
a quantization mode, a quantization bit quantity, a transform mode, or an entropy coding mode.

**12.** The method according to claim 11, wherein sending the compressed training data to the first communication apparatus comprises:
periodically sending the compressed training data to the first communication apparatus.

**13.** The method according to claim 11 or 12, wherein sending the compressed training data to the first communication apparatus comprises:

sending a resource request to the first communication apparatus;
receiving a resource allocation indication from the first communication apparatus; and
sending the compressed training data to the first communication apparatus based on the resource allocation indication.

**14.** The method according to claim 13, wherein the resource request is sent to the first communication apparatus based on at least one of the following:

an amount of the training data reaches a predetermined amount threshold; or
a percentage of the training data in data to be sent to the first communication apparatus reaches a predetermined percentage threshold.

**15.** The method according to any one of claims 11 to 14, further comprising:
sending the training data to a third communication apparatus.

**16.** The method according to any one of claims 11 to 15, wherein the training data is first training data, and the method further comprises:
receiving second training data from the third communication apparatus, wherein the first training data is determined based on the second training data.

**17.** The method according to any one of claims 1 to 16, wherein the dictionary is generated based on a basic training data set, and the basic training data set is selected from at least one predetermined basic training data set.

**18.** The method according to any one of claims 1 to 17, further comprising:

performing a dimension reduction operation on a to-be-sent multidimensional data matrix, to obtain a plurality of groups of low-dimensional data, wherein the first communication apparatus stores a plurality of dictionaries comprising the dictionary, and the plurality of dictionaries respectively correspond to the plurality of groups of low-dimensional data;
performing dictionary compression on the plurality of groups of low-dimensional data based on the plurality of dictionaries; and
sending the plurality of groups of low-dimensional data on which the dictionary compression is performed.

**19.** The method according to any one of claims 1 to 17, further comprising:

receiving a plurality of groups of low-dimensional data on which dictionary compression is performed;
performing, based on a plurality of dictionaries comprising the dictionary, dictionary decompression on the plurality of groups of low-dimensional data on which the dictionary compression is performed; and
performing a dimension increase operation on the plurality of groups of low-dimensional data on which the dictionary decompression is performed, to obtain a multidimensional data matrix.

20. A first communication apparatus, comprising modules or units configured to perform the method according to any one of claims 1 or 3 to 11, or claim 18 or 19.

21. A second communication apparatus, comprising modules or units configured to perform the method according to any one of claims 2 to 6, or any one of claims 12 to 19.

22. A first communication apparatus, comprising a processor, wherein the processor is coupled to a memory, the memory stores instructions, and when the instructions are executed by the processor, the first communication apparatus is caused to perform the method according to any one of claims 1 or 3 to 11, or claim 18 or 19.

23. A second communication apparatus, comprising a processor, wherein the processor is coupled to a memory, the memory stores instructions, and when the instructions are executed by the processor, the second communication apparatus is caused to perform the method according to any one of claims 2 to 6, or any one of claims 12 to 19.

24. A computer-readable storage medium, wherein the computer-readable storage medium stores instructions, and when the instructions are run, the method according to any one of claims 1 to 19 is performed.

25. A computer program product, wherein the computer program product comprises instructions, and when the instructions are run, the method according to any one of claims 1 to 19 is performed.

26. A communication system, comprising the first communication apparatus according to claim 20 or 22 and the second communication apparatus according to claim 21 or 23.

FIG. 1

200

210

First communication apparatus

220

Second communication apparatus

202

Obtain training data

204

Determine a group of to-be-updated subsets in a dictionary

206

Determine dictionary update information

Dictionary update information 212

208

214

216

Update the dictionary

FIG. 2

EP 4 694 311 A1

300A

To-be-trained subsets

To-be-updated subsets

Send an indication of the to-be-updated subsets and corresponding update values

| $x_1$ | $x_2$ | $x_3$ | $x_4$ | $x_5$ | $x_6$ | ⋮ | $x_{N-5}$ | $x_{N-4}$ | $x_{N-3}$ | $x_{N-2}$ | $x_{N-1}$ | $x_N$ |

Dict@t0

Training data $v_m$

| $x_1$ | $x_2$ | $x_3$ | $x_4$ | $x'_5$ | $x_6$ | ⋮ | $x_{N-5}$ | $x_{N-4}$ | $x_{N-3}$ | $x_{N-2}$ | $x'_{N-1}$ | $x_N$ |

Dict@t1

| $x'_5$ | $x'_{N-1}$ |

FIG. 3A

300B

| Update value | | Transform coefficient | | Discrete value | | |
|---|---|---|---|---|---|---|

Update
value → Transform → Transform
coefficient → Quantification → Discrete
value → Entropy
coding → Compressed
dictionary
update value
coded stream

FIG. 3B

300C

| index$_{quant}$ | bitwidth | index$_{trans}$ | index$_{entropy}$ |
|---|---|---|---|

FIG. 3C

400

Latest
data → Dictionary
compression → K groups of
dictionary subsets
and weighting
coefficients → Dictionary
decompression → Reconstructed
data → Calculate
a loss function

→ Selected data
as training data

FIG. 4

FIG. 5A

500B

110–1

| First terminal device |

120

| Network device |

502

| Share a dictionary |

522

| Trigger update |

Resource request 526

524 → 528

Resource allocation 532

534 ← 530

Training data 538

536 → 540

542

| Determine dictionary update information |

Dictionary update information 546

548 ← 544

550

| New shared dictionary |

FIG. 5B

600A

| 110–1 | 120 | 110–2 |
|-------|-----|-------|
| First terminal device | Network device | Second terminal device |

602

Share a dictionary

504

An update moment arrives

604

An update moment arrives

Training data 508    510    Training data 608

506                            606

512

Determine dictionary update information

Dictionary update information 516    514    Dictionary update information 516

518                            618

520

New shared dictionary

FIG. 6A

600B

110–1
**First terminal device**

120
**Network device**

110–2
**Second terminal device**

602
Share a dictionary

522
Trigger update

524 — Resource request 526 → 528

534 ← Resource allocation 532 — 530

536 — Training data 538 → 540

542
Determine dictionary update information

Dictionary update information 546 ← 544 → Dictionary update information 546

548 — 648

550
New shared dictionary

622
Trigger update

628 ← Resource request 626 — 624

630 — Resource allocation 632 → 634

640 ← Training data 638 — 636

642
Determine dictionary update information

Dictionary update information 646 ← 644 → Dictionary update information 646

548' — 648'

650
New shared dictionary

FIG. 6B

FIG. 7A

700B

Select K dictionary subsets

Obtain K groups of compressed coefficients and subset indications

To-be-compressed data v

Dictionary Dict

Weighting coefficient

×

...

≈

FIG. 7B

FDVs           SDVs

Rank 1   ...   Rank r     Rank 1   ...   Rank r

| 1 | ... | d | ... | 1 | ... | d | 1 | ... | d | ... | 1 | ... | d |

| $L_{coeff,\,1}$ bits | $L_{idx,\,1}$ bits | $\times K_1$ | | $L_{coeff,\,2}$ bits | $L_{idx,\,2}$ bits | $\times K_2$ |

$r \times d \times \Sigma_{i=1}^{2}\, K_i \times (L_{coeff,\,i} + L_{idx,\,i})$ bits

**FIG. 8A**

Rank 1                  Rank r

FDVs    SDVs    ...    FDVs    SDVs

| 1 | ... | d | 1 | ... | d | ... | 1 | ... | d | 1 | ... | d |

**FIG. 8B**

| d | K | $L_{coeff}$ | $L_{idx,\,1}$ | $L_{idx,\,2}$ |

**FIG. 9A**

| d | $K_1$ | $L_{coeff,\,1}$ | $L_{idx,\,1}$ | $K_2$ | $L_{coeff,\,2}$ | $L_{idx,\,2}$ |

**FIG. 9B**

| $L_{idx,\,1}$ | $L_{idx,\,2}$ | $d_1$ | $K_1$ | $L_{coeff,\,1}$ | ... | $d_r$ | $K_r$ | $L_{coeff,\,r}$ |

Rank 1                 Rank r

**FIG. 9C**

| $L_{idx,\,1}$ | $L_{idx,\,2}$ | $d_1$ | $K_{1,1}$ | $L_{coeff,\,1,\,1}$ | $K_{2,\,1}$ | $L_{coeff,\,2,\,1}$ | ... | $d_r$ | $K_{1,\,r}$ | $L_{coeff,\,1,\,r}$ | $K_{2,\,r}$ | $L_{coeff,\,2,\,r}$ |

Rank 1                 Rank r

**FIG. 9D**

1000

1020

A first communication apparatus obtains training data, where the training data is used to train a dictionary used for data compression

1040

Determine a group of to-be-updated subsets in the dictionary based on the training data

1060

Determine dictionary update information corresponding to the group of to-be-updated subsets

1080

Send the dictionary update information

FIG. 10

1100

1120

A second communication apparatus receives, from a
first communication apparatus, dictionary update
information for a dictionary used for data compression,
where the dictionary update information includes
indication information of subsets in a group of to-be-
updated subsets in the dictionary and update values for
the subsets in the group of to-be-updated subsets

1140

Update the dictionary based on the dictionary update
information

FIG. 11

Communication
apparatus 1200

Processing
unit
1210

Receiving
unit
1220

Sending unit
1230

FIG. 12

FIG. 13

## INTERNATIONAL SEARCH REPORT

| International application No. |
| --- |
| **PCT/CN2023/091226** |

| A. | CLASSIFICATION OF SUBJECT MATTER |
| --- | --- |

H04W28/06(2009.01)i; H04L69/04(2022.01)i

According to International Patent Classification (IPC) or to both national classification and IPC

| B. | FIELDS SEARCHED |
| --- | --- |

Minimum documentation searched (classification system followed by classification symbols)

IPC:H04W,H04L

Documentation searched other than minimum documentation to the extent that such documents are included in the fields searched

Electronic data base consulted during the international search (name of data base and, where practicable, search terms used)

CNABS, CNTXT, CNKI, VEN, USTXT, EPTXT, IEEE: 更新, 数据压缩, 字典, 训练, 动态, 局部, update, data, compression, dictionary, training, dynamic, part

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | US 2014070966 A1 (FABLET YOUENN et al.) 13 March 2014 (2014-03-13) description, paragraphs [0159]-[0304], and figures 4-9 | 1-26 |
| X | US 5530645 A (APPLE COMPUTER INC.) 25 June 1996 (1996-06-25) description, column 3, line 23 to column 5, line 24, and figures 4-7 | 1-26 |
| A | CN 108846430 A (LANZHOU UNIVERSITY OF TECHNOLOGY) 20 November 2018 (2018-11-20) entire document | 1-26 |
| A | CN 107645538 A (ALIBABA GROUP HOLDING LIMITED) 30 January 2018 (2018-01-30) entire document | 1-26 |
| A | CN 111193752 A (GUANGZHOU BAIGUOYUAN INFORMATION TECHNOLOGY CO., LTD.) 22 May 2020 (2020-05-22) entire document | 1-26 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 December 2023** | **03 January 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/091226**

| Patent document cited in search report | | | Publication date (day/month/year) | Patent family member(s) | | | Publication date (day/month/year) |
|---|---|---|---|---|---|---|---|
| US | 2014070966 | A1 | 13 March 2014 | US | 8698657 | B2 | 15 April 2014 |
| US | 5530645 | A | 25 June 1996 | None | | | |
| CN | 108846430 | A | 20 November 2018 | CN | 108846430 | B | 22 February 2022 |
| CN | 107645538 | A | 30 January 2018 | None | | | |
| CN | 111193752 | A | 22 May 2020 | None | | | |

Form PCT/ISA/210 (patent family annex) (July 2022)